(19) Europäisches Patentamt / European Patent Office / Office européen des brevets

(11) **EP 4 730 052 A1**

(12) **EUROPEAN PATENT APPLICATION**

(43) Date of publication:
**22.04.2026 Bulletin 2026/17**

(21) Application number: **25207972.8**

(22) Date of filing: **10.10.2025**

(51) International Patent Classification (IPC):
*G04F 10/00* (2006.01)

(52) Cooperative Patent Classification (CPC):
**G04F 10/005**

(84) Designated Contracting States:
**AL AT BE BG CH CY CZ DE DK EE ES FI FR GB GR HR HU IE IS IT LI LT LU LV MC ME MK MT NL NO PL PT RO RS SE SI SK SM TR**
Designated Extension States:
**BA**
Designated Validation States:
**GE KH LA MA MD TN**

(30) Priority: **18.10.2024 KR 20240143450**

(71) Applicant: **SDT Inc.**
**Seoul 06211 (KR)**

(72) Inventor: **PARK, Byung Kwon**
**16238 Suwon-si (KR)**

(74) Representative: **Manasse, Uwe**
**Boehmert & Boehmert**
**Anwaltspartnerschaft mbB**
**Pettenkoferstrasse 22**
**80336 München (DE)**

(54) **A DEVICE FOR TIME TAGGING MEASUREMENT**

(57) An FPGA is disclosed which includes a group of TDCs, a clock generator for providing a clock in common to the group of TDCs, a tag counter configured to provide a counted value of the clock, known as a tag count, in common to the group of TDCs, and a processing unit. An arbitrary TDC comprises an input signal generation part for generating an input pulse having a rising edge that occurs at the same time as the rising edge of a start signal input to the TDC, and a delay line part into which the generated input pulse is input. The processing unit is configured to calculate a first value by multiplying the value of the tag count observed at the occurrence time of the first newly generated clock pulse of the clock after the rising edge of the start signal has occurred by the pulse period of the clock, and to calculate the occurrence time of the first start signal by subtracting, from the first value, a thermometer code output by the delay line part or a converted code obtained by converting the thermometer code at the rising edge time of the first newly generated clock pulse.

[FIG. 10]

EP 4 730 052 A1

## Description

### [Technical Field]

The present invention relates to a technology concerning Time-to-Digital Converters (TDCs), and more particularly, to a TDC technology capable of tagging the occurrence time of a pulse signal.

### [Background Art]

A Time-to-Digital Converter (TDC) plays a crucial role in many scientific and industrial application fields that require precise timing measurements. It is widely used in applications requiring high-precision timing measurements, such as time-of-flight (TOF) measurements in particle physics, medical imaging, radar systems, and laser distance measurement.

A TDC can convert the time interval between two events into a digital output. TDCs designed to measure the time difference between two events typically use a counter to count the number of clock cycles between the two events. Then, the count is converted into a digital output representing the time interval. There are various types of TDCs, such as leading-edge TDCs, trailing-edge TDCs, and interpolation TDCs. A leading-edge TDC measures the time between the leading edge of a start signal and the leading edge of a stop signal, while a trailing-edge TDC measures the time between the trailing edge of a start signal and the trailing edge of a stop signal. An interpolation TDC increases the resolution of the TDC by using interpolation techniques to estimate the time interval between two clock cycles.

As a prerequisite for determining a measurement value, the TDC providing the aforementioned functions needs to time-tag one or more independent signals with reference to a specific time, rather than just measuring the interval between two pulses occurring on a single channel. To achieve this, it is necessary to input only a single signal representing one event into the TDC for each channel and provide a technology to tag and store the occurrence time of the said input signal as a number.

### [Summary of the Invention]

### [Problem to be Solved]

The present invention aims to provide a TDC that offers the function of time-tagging the occurrence time of a single signal representing a single event.

### [Solution to the Problem]

TDCs can be implemented using ASICs (Application-Specific Integrated Circuits), MCUs (Microcontrollers), PSoCs (Programmable System-on-Chip), DSPs (Digital Signal Processors), FPAAs (Field Programmable Analog Arrays), TACs (Time-to-Amplitude Converters), TFCs (Time-to-Frequency Converters), and FPGAs (Field Programmable Gate Arrays), among others.

When implementing a TDC using an FPGA, the following problems may arise. First, the resources provided in an FPGA, including logic cells, look-up tables (LUTs), and routing channels, are limited, which can limit the resolution and accuracy of the TDC implemented in the FPGA. Second, at high clock frequencies, jitter can introduce errors into the TDC measurement. Here, jitter refers to variations in the timing of the clock signal due to factors such as noise and temperature. Third, due to factors such as voltage drops, temperature changes, and manufacturing process variations, the TDC can exhibit non-linear behavior, resulting in errors in high-resolution TDC measurements. Fourth, FPGAs introduce delays through signal processing and routing, and these delays can introduce errors in TDC measurements for small time intervals.

In an FPGA, routing is the process of connecting programmable logic elements (e.g., look-up tables, flip-flops, and multiplexers) on the chip to form the desired logic circuit. Routing determines how signals propagate through the chip and can significantly impact the overall performance of the design. One of the main factors that can cause delay in FPGA routing is the capacitance of the interconnect wires connecting the logic elements. As the number of logic elements and the distance between them increase, the capacitance of the interconnect wires also increases. This capacitance can delay signal propagation through the wires, increasing the overall design delay. Another factor that can cause delay in FPGA routing is routing congestion. FPGA routing resources are limited, and when there are many logic elements to connect, routing congestion can occur. Routing congestion increases the distance between logic elements, thereby increasing the capacitance of the interconnect wires and causing delays.

A tapped delay line is a digital signal processing technique used to implement a thermometer code. In a thermometer code, each bit of a binary number is represented by a separate signal line, and the lines corresponding to "on" bits represent the value of the binary number. To implement a thermometer code using a tapped delay line, a series of delay elements representing each bit is used. The input binary number is converted into a series of pulses, with each pulse representing one bit of the binary number. These pulses are fed into the tapped delay line after being delayed by different amounts depending on the position of each bit. At the output of the tapped delay line, each output signal line represents a bit of the binary number, and the "on" lines represent the value of the binary number. This technique is commonly used in digital-to-analog converters (DACs) to convert digital signals to analog signals.

In an FPGA, a carry chain block is a hardware block used to perform fast arithmetic operations, especially addition and subtraction. In digital circuits, the addition and subtraction of multi-bit numbers require the calculation of carry bits, which can become a bottleneck in high-speed operations. The carry chain block efficiently handles the calculation of these carry bits, enabling faster and more efficient arithmetic operations. The carry chain block is typically composed of a series of full adder circuits connected in a specific way to form a carry chain. Each full adder circuit calculates one bit of the output and the carry bit that is passed to the next stage of the chain. By connecting these full adder circuits in a chain, the carry bit can propagate through the chain within one clock cycle, allowing for fast addition and subtraction of multi-bit numbers. In addition to providing fast arithmetic operations, carry chain blocks can also be used to implement counters and other sequential circuits that require the calculation of carry bits.

A timing report tool is a software tool used to analyze the timing performance of a design implemented in an FPGA. This tool generates a report that provides information about the timing characteristics of the design. This report includes information on the design's timing characteristics, such as data path delay, critical path, setup and hold times, clock skew, and maximum operating frequency. The data path delay is the time it takes for a data signal to propagate through the logic elements of the FPGA.

A multiplexer, abbreviated as "MUX," is an electronic circuit that selects one of several input signals and forwards the selected input to an output line. The input-output structure of a multiplexer generally consists of multiple input lines, select lines, and one or more output lines. The number of input lines corresponds to the number of input signals the multiplexer can select from, and the select lines determine the selected input signal. For example, a 4-to-1 multiplexer has four input lines, one output line, and select lines that determine which of the four input signals is transmitted to the output. The select lines are controlled by a binary code that represents the selected input line. Multiplexers are often used in digital systems to reduce the number of wires needed to transmit data and control signals. They can be used to implement functions such as data selectors, memory address decoders, and bus arbitration circuits. According to one aspect of the present invention, an FPGA (1) is provided, which is programmed to include a first delay line part (20) into which an input pulse having a width corresponding to the time difference between the occurrence of a start signal and a stop signal is input; a code conversion part (30) that converts the order of the elements of a thermometer code output by the first delay line part and outputs the result; and a computation part (60) that determines the said time difference of occurrence using the converted code output by the code conversion part. The converted code is one in which the order of the elements of the said thermometer code is sorted according to a predetermined criterion, and the said predetermined criterion may be the data path delay from the output node of the said input pulse to the respective output nodes of a plurality of flip-flops (FF) included in the said first delay line part.

In this case, the said FPGA (1) may be programmed to further include a second delay line part into which the said input pulse is input, and the said code conversion part may be configured to sort and merge the elements of the thermometer code output by the said first delay line part and the elements of the thermometer code output by the said second delay line part according to a second predetermined criterion to generate the said converted code. The said second predetermined criterion may be the data path delay from the output node of the said input pulse to the respective output nodes of a plurality of flip-flops included in the said first delay line part and the said second delay line part.

In this case, the said FPGA (1) may be programmed to further include: an input signal generation part (10) that generates the said input pulse having a width equal to the time difference between the rising edge of the said start signal and the rising edge of the said stop signal; a clock pulse count part (40) that counts the number of clock pulses generated during the duration of the said input pulse; and the said computation part may be configured to determine the value of the said time difference of occurrence by using a first thermometer code (TC1) output by the said code conversion part at the time of the rising edge of the first clock pulse among the said generated clock pulses, a second thermometer code (TC2) output by the said code conversion part at the time of the rising edge of the clock pulse occurring immediately after the last clock pulse among the said generated clock pulses, and the number of the said counted clock pulses.

According to another aspect of the present invention, an FPGA is provided, which is programmed to include: a plurality of delay line parts into which an input pulse having a width corresponding to the time difference between the occurrence of a start signal and a stop signal is input; a code conversion part that merges a plurality of thermometer codes output by the plurality of delay line parts and outputs a single converted code; and a computation part that determines the said time difference of occurrence using the said converted code. The said converted code is one in which the order of the elements of the said plurality of thermometer codes is sorted according to a predetermined criterion, and the said predetermined criterion may be the data path delay from the output node of the said input pulse to the respective output nodes of a plurality of flip-flops included in the plurality of delay line parts.

In this case, the said FPGA may be programmed to further include: an input signal generation part that generates the said input pulse having a width equal to the time difference between the rising edge of the said start signal and the rising edge of the said stop signal; a clock pulse count part that counts the number of clock pulses generated during the duration of the said input pulse; and the said computation part may be configured to determine the value of the said time difference of occurrence by using a first thermometer code (TC1) output by the said code conversion part at the time of the rising edge of the first clock pulse among the said generated clock pulses, a second thermometer code (TC2) output by the said code conversion part at the time of the rising edge of the clock pulse occurring immediately after the last clock pulse among the said generated clock pulses, and the number of the said counted clock pulses.

According to one aspect of the present invention, a non-volatile recording medium readable by an electronic device is provided, on which a binary file containing configuration data is recorded. This data is for programming an FPGA to implement a digital circuit that includes: a first delay line part (20) into which an input pulse having a width corresponding to the time difference between the occurrence of a start signal and a stop signal is input; a code conversion part (30) that converts the order of the elements of a thermometer code output by the first delay line part and outputs the result; and a computation part (60) that determines the said time difference of occurrence using the converted code output by the code conversion part. In this case, the converted code is one in which the order of the elements of the said thermometer code is sorted according to a predetermined criterion, and the said predetermined criterion may be the data path delay from the output node of the said input pulse to the respective output nodes of a plurality of flip-flops (FF) included in the said first delay line part.

In this case, the said digital circuit may further include a second delay line part into which the said input pulse is input, and the said code conversion part may be configured to sort and merge the elements of the thermometer code output by the said first delay line part and the elements of the thermometer code output by the said second delay line part according to a second predetermined criterion to generate the said converted code. The said second predetermined criterion may be the data path delay from the output node of the said input pulse to the respective output nodes of a plurality of flip-flops included in the said first delay line part and the said second delay line part.

In this case, the said digital part may further include: an input signal generation part (10) that generates the said input pulse having a width equal to the time difference between the rising edge of the said start signal and the rising edge of the said stop signal; a clock pulse count part (40) that counts the number of clock pulses generated during the duration of the said input pulse; and the said computation part may be configured to determine the value of the said time difference of occurrence by using a first thermometer code (TC1) output by the said code conversion part at the time of the rising edge of the first clock pulse among the said generated clock pulses, a second thermometer code (TC2) output by the said code conversion part at the time of the rising edge of the clock pulse occurring immediately after the last clock pulse among the said generated clock pulses, and the number of the said counted clock pulses.

According to another aspect of the present invention, a non-volatile recording medium readable by an electronic device is provided, on which a binary file containing configuration data is recorded. This data is for programming an FPGA to implement a digital circuit that includes: a plurality of delay line parts into which an input pulse having a width corresponding to the time difference between the occurrence of a start signal and a stop signal is input; a code conversion part that merges a plurality of thermometer codes output by the plurality of delay line parts and outputs a single converted code; and a computation part that determines the said time difference of occurrence using the said converted code. The converted code is one in which the order of the elements of the said plurality of thermometer codes is sorted according to a predetermined criterion, and the said predetermined criterion may be the data path delay from the output node of the said input pulse to the respective output nodes of a plurality of flip-flops included in the plurality of delay line parts.

According to one aspect of the present invention, a TDC system is provided, which may include: a PCB board (100) including the aforementioned FPGA (1); and a computing device (200) that acquires the said time difference of occurrence from the said PCB board.

According to one aspect of the present invention, a non-volatile recording medium readable by an electronic device is provided, on which a binary file containing configuration data is recorded. This data is for programming an FPGA to implement a digital circuit that includes: a group of TDCs; a clock generator for generating a clock and providing it in common to the said group of TDCs; a tag counter configured to generate a second count, which is the counted value of the said clock, and provide it in common to the said group of TDCs; and a processing unit. Any TDC among the said group of TDCs includes an input signal generation part that generates an input pulse having a rising edge that occurs at the same time as the rising edge of a start signal input to the said arbitrary TDC; and a delay line part into which the said generated input pulse is input. In this case, the said processing unit is configured to calculate a first value by multiplying the value of the said second count (TC) observed at the occurrence time of the first newly generated clock pulse of the said clock after the rising edge of the said start signal input to the said arbitrary TDC occurs, by the pulse period (CP) of the said clock, and to calculate the occurrence time of the said first start signal by subtracting the thermometer code output by the said delay line part or the converted code obtained by converting the said thermometer code at the rising edge time of the said first newly generated clock pulse from the said first value.

In this case, the said arbitrary TDC is configured to operate in either a first mode or a second mode, wherein the said arbitrary TDC is configured to generate the said input pulse in both the said first mode and the said second mode, and the said arbitrary TDC may be configured to receive a stop signal in the said first mode. And when the said stop signal is input to the said arbitrary TDC, the said input signal generation part may be configured to generate the said input pulse such that its width is equal to the time difference between the rising edge of the said start signal and the rising edge of the said stop signal. And the said processing unit is configured to calculate the time difference of occurrence between the said start signal and the said stop signal using the thermometer code output by the delay line part of the said arbitrary TDC at the rising edge time of the said first newly generated clock pulse when the said arbitrary TDC operates in the said first mode, and is configured to calculate the occurrence time of the said start signal when the said arbitrary TDC operates in the said second mode.

In this case, the said arbitrary TDC may further include a clock pulse count part that counts the number of clock pulses of the said clock generated during the duration of the said input pulse. And when the said arbitrary TDC operates in the said first mode, the said processing unit may be configured to determine the value of the said time difference of occurrence by using the thermometer code output by the said delay line part at the rising edge time of the first clock pulse among the clock pulses generated during the duration of the said input pulse, the thermometer code output by the said delay line part at the rising edge time of the clock pulse occurring immediately after the last clock pulse among the clock pulses generated during the duration of the said input pulse, and the number of clock pulses counted by the said clock pulse count part.

In this case, the said arbitrary TDC may further include: a code conversion part that outputs a converted code generated by converting the order of the elements of the thermometer code output by the said delay line part; and a clock pulse count part that counts the number of clock pulses of the said clock generated during the duration of the said input pulse. And when the said arbitrary TDC operates in the said first mode, the said processing unit may be configured to determine the value of the said time difference of occurrence by using the first thermometer code output by the said code conversion part at the rising edge time of the first clock pulse among the clock pulses generated during the duration of the said input pulse, the second thermometer code output by the said code conversion part at the rising edge time of the clock pulse occurring immediately after the last clock pulse among the clock pulses generated during the duration of the said input pulse, and the number of clock pulses counted by the said clock pulse count part.

In this case, the said processing unit may be configured to determine the relationship between a first occurrence time, which is the occurrence time of the said start signal input to the said arbitrary TDC among the said group of TDCs, and a second occurrence time, which is the occurrence time of a second start signal input to another TDC among the said group of TDCs. And on the circuit plane of the said FPGA, the said tag counter may be placed inside the regions occupied by the said group of TDCs, which are interconnected.

According to one aspect of the present invention, an FPGA may be provided, which is programmed to include: a group of TDCs (100) having the same configuration; a clock generator (140) for generating a clock and providing the said generated clock in common to the said group of TDCs; a tag counter (130) configured to generate a second count, which is the counted value of the said clock, and provide the said generated second count in common to the said group of TDCs; and a processing unit (160). A first TDC among the said group of TDCs includes: an input signal generation part (10) that generates a first input pulse (P1) having a rising edge that occurs at the same time as the rising edge of a first start signal (S1) input to the said first TDC; and a delay line part (20) into which the said generated first input pulse is input. The said processing unit is configured to calculate a first value by multiplying the value of the said second count (TC) observed at the occurrence time of the first newly generated clock pulse of the said clock after the rising edge of the said first start signal input to the said first TDC occurs, by the pulse period (CP) of the said clock, and to calculate the occurrence time of the said first start signal by subtracting the thermometer code output by the delay line part of the said first TDC or the converted code obtained by converting the said thermometer code from the said first value.

In this case, the said first TDC is configured to operate in either a first mode or a second mode, wherein the said first TDC is configured to generate the said first input pulse in both the said first mode and the said second mode, and the said first TDC may be configured to receive a first stop signal in the said first mode. And when the said first stop signal is input to the said first TDC, the said input signal generation part may be configured to generate the said first input pulse such that its width is equal to the time difference between the rising edge of the said first start signal and the rising edge of the said first stop signal. And the said processing unit is configured to calculate the time difference of occurrence between the said first start signal and the said first stop signal using the thermometer code output by the delay line part of the said first TDC at the rising edge time of the said first newly generated clock pulse when the said first TDC operates in the said first mode, and is configured to calculate the occurrence time of the said first start signal when the said first TDC operates in the said second mode.

In this case, the said first TDC may further include a clock pulse count part (40) that counts the number of clock pulses of the said clock generated during the duration of the said first input pulse. And when the said first TDC operates in the said first mode, the said processing unit may be configured to determine the value of the said time difference of occurrence by using the thermometer code output by the said delay line part at the rising edge time of the first clock pulse among the clock pulses generated during the duration of the said first input pulse, the thermometer code output by the said delay line part at the rising edge time of the clock pulse occurring immediately after the last clock pulse among the clock pulses generated during the duration of the said first input pulse, and the number of clock pulses counted by the said clock pulse count part.

In this case, the said first TDC may further include: a code conversion part (30) that outputs a converted code generated by converting the order of the elements of the thermometer code output by the said delay line part; and a clock pulse count part (40) that counts the number of clock pulses of the said clock generated during the duration of the said first input pulse. And when the said first TDC operates in the said first mode, the said processing unit may be configured to determine the value of the said time difference of occurrence by using the first thermometer code output by the said code conversion part at the rising edge time of the first clock pulse among the clock pulses generated during the duration of the said first input pulse, the second thermometer code output by the said code conversion part at the rising edge time of the clock pulse occurring immediately after the last clock pulse among the clock pulses generated during the duration of the said first input pulse, and the number of clock pulses counted by the said clock pulse count part.

In this case, the said converted code is one in which the order of the elements of the thermometer code output by the said delay line part is sorted according to a predetermined criterion, and the said predetermined criterion may be the data path delay from the output node of the said first input pulse to the respective output nodes of a plurality of flip-flops (FF) included in the said delay line part.

In this case, the said processing unit may be configured to determine the relationship between a first occurrence time, which is the occurrence time of the said first start signal input to the said first TDC among the said group of TDCs, and a second occurrence time, which is the occurrence time of a second start signal input to a second TDC among the said group of TDCs. And on the circuit plane of the said FPGA, the said tag counter may be placed inside an area (1000) that interconnects the regions occupied by the said group of TDCs.

In this case, the said first TDC may further include: a clock pulse count part (40) that outputs a first count, which is the result of counting the number of clock pulses of the said clock generated during the duration of the said first input pulse; and a count selection part (60) configured to select and output the said first count among the said first count and the said second count in the said first mode, and to select and output the said second count among the said first count and the said second count in the said second mode.

In this case, when the said first stop signal is not input to the said first TDC operating in the said first mode, the said processing unit may be configured to extinguish the said first input pulse upon completion of the calculation of the occurrence time of the said first start signal.

According to another aspect of the present invention, a non-volatile recording medium is provided, in which program instructions executable on an electronic device are stored. The said electronic device includes a group of TDCs with identical configurations, a clock generator for providing a clock in common to the said group of TDCs, a tag counter configured to generate a second count, which is the counted value of the said clock, and provide it in common to the said group of TDCs, and a processing unit. Each of the said TDCs includes an input signal generation part and a delay line part. When the said program instructions are executed on the said electronic device, the following steps are performed: a step where the input signal generation part of an arbitrary TDC among the said group of TDCs generates an input pulse having a rising edge that occurs at the same time as the rising edge of a start signal input to the said arbitrary TDC; a step where the delay line part of the said arbitrary TDC outputs one of a thermometer code of the said input pulse and a converted code obtained by converting the said thermometer code, at the rising edge time of the first newly generated clock pulse of the said clock after the rising edge of the said start signal has occurred; and a step where the said processing unit calculates a first value by multiplying the value of the said second count observed at the occurrence time of the said first newly generated clock pulse of the said clock by the pulse period of the said clock, and then calculates the occurrence time of the said first start signal by subtracting one of the said output codes from the said first value.

In this case, when the said program instructions are executed on the said electronic device, the said arbitrary TDC is configured to operate in either a first mode or a second mode, the said arbitrary TDC is configured to generate the said input pulse in both the said first mode and the said second mode, and the said arbitrary TDC is configured to receive a stop signal in the said first mode. When the said stop signal is input to the said arbitrary TDC, the said input signal generation part is configured to generate the said input pulse such that its width is equal to the time difference between the rising edge of the said start signal and the rising edge of the said stop signal. And the said processing unit is configured to calculate the time difference of occurrence between the said start signal and the said stop signal using one of the said codes output by the delay line part of the said arbitrary TDC at the rising edge time of the said first newly generated clock pulse when the said arbitrary TDC operates in the said first mode, and conversely, is configured to calculate the occurrence time of the said start signal when the said arbitrary TDC operates in the said second mode.

In this case, each of the said TDCs may further include a clock pulse count part that counts the number of clock pulses of the said clock generated during the duration of the said input pulse. And when the said program instructions are executed on the said electronic device, the said processing unit, when the said arbitrary TDC operates in the said first mode, is configured to execute a step of determining the value of the said time difference of occurrence by using one of the said codes output by the said delay line part at the rising edge time of the first clock pulse among the clock pulses generated during the duration of the said input pulse, one of the said codes output by the said delay line part at the rising edge time of the clock pulse occurring immediately after the last clock pulse among the clock pulses generated during the duration of the said input pulse, and the number of clock pulses counted by the said clock pulse count part.

In this case, each of the said TDCs may further include: a code conversion part that outputs a converted code generated by converting the order of the elements of the thermometer code output by the said delay line part; and a clock pulse count part that counts the number of clock pulses of the said clock generated during the duration of the said input pulse. And when the said program instructions are executed on the said electronic device, the said processing unit, when the said arbitrary TDC operates in the said first mode, may be configured to further execute a step of determining the value of the said time difference of occurrence by using the first thermometer code output by the said code conversion part at the rising edge time of the first clock pulse among the clock pulses generated during the duration of the said input pulse, the second thermometer code output by the said code conversion part at the rising edge time of the clock pulse occurring immediately after the last clock pulse among the clock pulses generated during the duration of the said input pulse, and the number of clock pulses counted by the said clock pulse count part.

In this case, when the said program instructions are executed on the said electronic device, the said processing unit may be configured to further execute a step of determining the relationship between a first occurrence time, which is the occurrence time of the said start signal input to the said arbitrary TDC among the said group of TDCs, and a second occurrence time, which is the occurrence time of a second start signal input to another TDC among the said group of TDCs. On the circuit plane of the said FPGA, the said tag counter may be placed inside the regions occupied by the said group of TDCs, which are interconnected.

In this case, the said electronic device may be an FPGA. According to another aspect of the present invention, a TDC system is provided, which includes: a PCB board (100) including the aforementioned FPGA; and a computing device (200) that acquires the said time difference of occurrence from the said PCB board.

** [Effects of the Invention] **

According to the present invention, a TDC can be provided that offers the function of time-tagging the occurrence time of a single signal representing a single event.

** [Brief Description of the Drawings] **

FIG. 1 is a block diagram showing the configuration of an FPGA according to an embodiment of the present invention.
FIG. 2 is a diagram for explaining the input pulse input to the first delay line part according to an embodiment of the present invention.
FIG. 3 is a diagram showing the configuration of the first delay line part according to an embodiment of the present invention.
FIG. 4 is a diagram for explaining the indices of the buffers in FIG. 3.
FIG. 5 is a table for explaining the data path delay according to an embodiment of the present invention.
FIG. 6a and FIG. 6b show a parallel configuration of multiple delay line parts according to an embodiment of the present invention.
FIG. 7a shows the configuration of the first delay line part and the second delay line part of FIG. 6b.
FIG. 7b shows the change in the configuration of the FPGA of FIG. 1 when a second delay line part is added in addition to the first delay line part.
FIG. 7c is for explaining the operation of the code conversion part when two delay line parts are used according to an embodiment of the present invention.
FIG. 8 is a graph of the delay according to the application of the code conversion part in an embodiment of the present invention.
FIG. 9 is a diagram for explaining the array criterion of flip-flop output values and the increment in the number of taps in FIG. 8, depending on the application of the code conversion part, according to an embodiment of the present invention.
FIG. 10 shows the configuration of an FPGA provided according to a preferred embodiment of the present invention.
FIG. 11a to FIG. 11c are diagrams for explaining the configuration and operation method of any one of the multiple TDCs shown in FIG. 10.
FIG. 12 is a diagram for explaining the input pulse input to the delay line part according to an embodiment of the present invention.
FIG. 13a shows the relative positions of the multiple TDCs, the tag counter, and the input multiplexer presented in FIG. 10 on the surface of the actual circuit implemented on an FPGA, according to an embodiment of the present invention.
FIG. 13b and FIG. 13c conceptually represent the features of the present invention presented in FIG. 13a.
FIG. 14 is a flowchart showing a method for calculating the occurrence time of an input predetermined signal, provided according to an embodiment of the present invention.

FIG. 15 is a flowchart showing a method for calculating the time difference of occurrence between an input predetermined start signal and stop signal, provided according to an embodiment of the present invention.

FIG. 16 is a block diagram of a TDC system provided according to an embodiment of the present invention.

[Detailed Description of the Embodiments]

Hereinafter, embodiments of the present invention will be described with reference to the accompanying drawings. However, the present invention is not limited to the embodiments described herein and can be implemented in various other forms. The terms used in this specification are for the purpose of helping to understand the embodiments and are not intended to limit the scope of the present invention. In addition, the singular forms used below include the plural forms unless the context clearly dictates otherwise.

<Configuration for measuring the time difference of occurrence between two events>

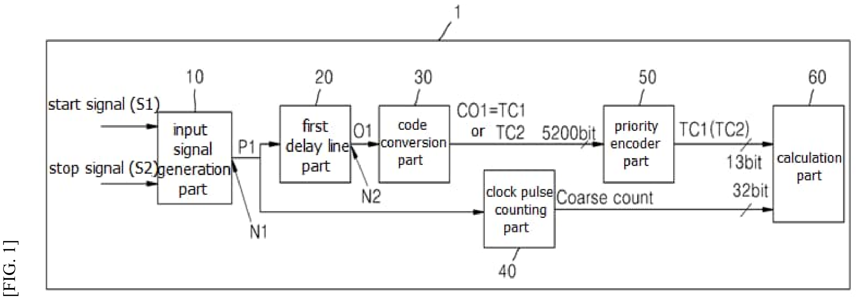

FIG. 1 is a block diagram showing the configuration of an FPGA according to an embodiment of the present invention.

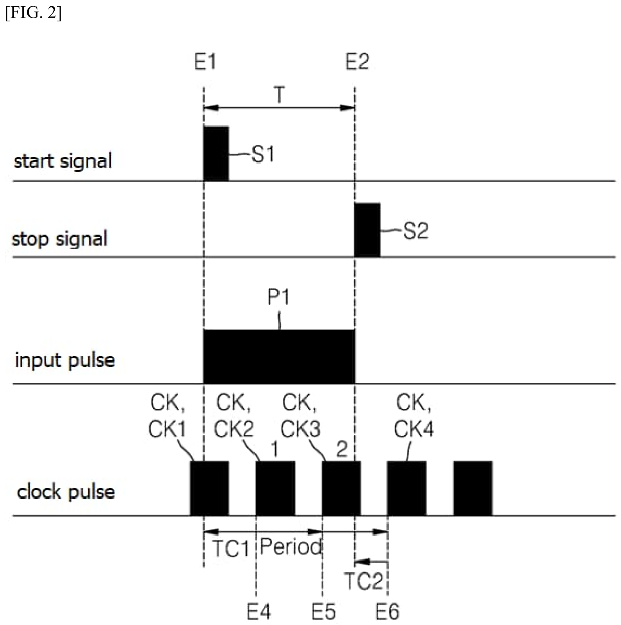

FIG. 2 is a diagram for explaining the input pulse input to the first delay line part according to an embodiment of the present invention.

Hereinafter, description will be provided with reference to FIG. 1 and FIG. 2 together. The FPGA (1) may include an input signal generation part (10), a first delay line part (20), a code conversion part (30), a clock pulse count part (40), a priority encoder part (50), and a computation part (60).

Specifically, the components of the aforementioned FPGA (1) can be the components of a TDC (Time to Digital converter).

As shown in FIG. 2, the input signal generation part (10) can generate an input pulse (P1) having a width equal to the time difference of occurrence (T) between a given start signal (S1)'s rising edge (E1) and a given stop signal (S2)'s rising edge (E2). The input signal generation part (10) can be configured with the necessary logic gates for said generation.

The first delay line part (20) can receive the input pulse (P1) having a width equal to the time difference of occurrence (T) of the start signal (S1) and the stop signal (S2). And the first delay line part (20) can output a thermometer code (01). At this time, the thermometer code is a value of, for example, 8 bits composed of the output values of flip-flops included in the first delay line part (20), and the output value of each flip-flop can be referred to as an element of the thermometer code.

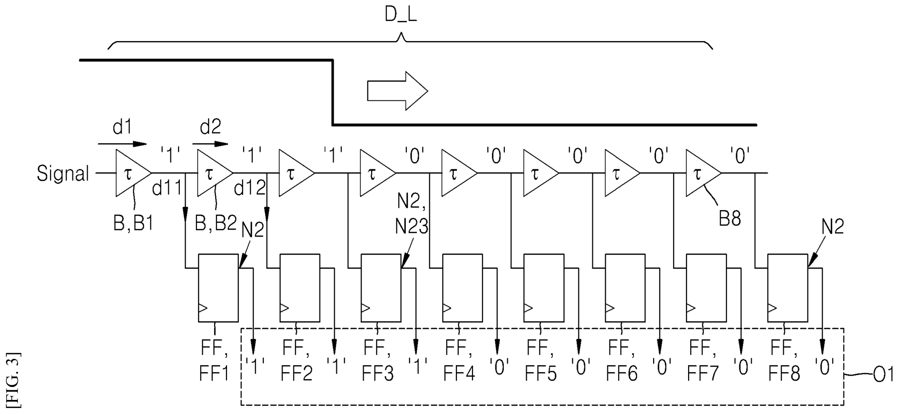

FIG. 3 shows the configuration of the first delay line part according to an embodiment of the present invention.

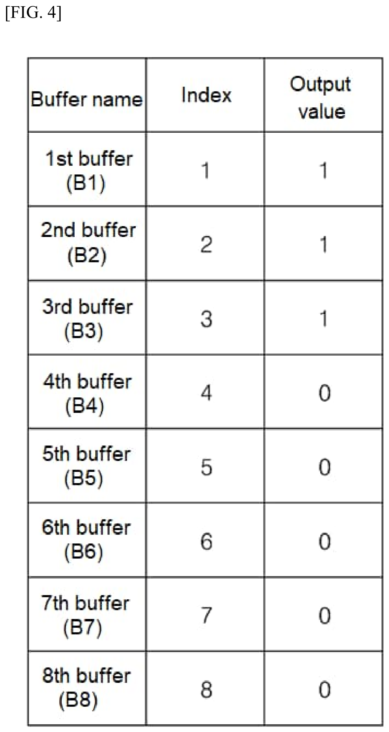

FIG. 4 is a diagram for explaining the indices of the buffers in FIG. 3.

The first delay line part (20) may include a delay line (D_L) comprising a plurality of buffers (delay elements, delay components) (B) and D-flip-flops (FF) tapped at the output terminal of each buffer (B) of the said delay line.

The plurality of buffers can be connected in a cascade delay manner. That is, the plurality of buffers can be arranged in the order in which the input pulse (P1) flows. The waveform (Signal) of the input pulse (P1) in FIG. 3 can be output with a certain delay at the output terminal of each buffer (B). That is, the output value of the first buffer (B1) is output with a certain delay at the output terminal of the first buffer (B1), and the output terminal of the first buffer (B1) is connected to the input terminal of the second buffer (B2). The output value (e.g., '1') of the first buffer (B1) can also be input to the first flip-flop (FF1).

That is, a signal that enters the input terminal of the [k]-th buffer is output with a certain delay at the output terminal of the [k]-th buffer. And the output terminal of the [k]-th buffer is connected to the input terminal of the [k+1]-th buffer. The output value (e.g., '1' or '0') of the [k]-th buffer is also input to the [k]-th flip-flop.

At this time, a data path delay can occur between each buffer (B) and through the flip-flop (FF). For example, a delay of d1 can occur until the input value ('1') of the first buffer (B1) is delivered to the second buffer (B2), and a delay of d11 can occur until the output value ('1') of the first buffer (B1) is delivered to the first flip-flop (FF1). Similarly, a delay occurs each time data is delivered from a previous buffer to the next buffer, and a delay occurs each time data is delivered from an arbitrary buffer to the flip-flop connected to that arbitrary buffer.

FIG. 4 is a diagram for explaining the index of a buffer according to an embodiment of the present invention.

Each field in the table of FIG. 4 represents the buffer name, index, and the output value of each buffer.

An index defining the connection order of each buffer can be assigned to each buffer. For example, index '1' is assigned to the first buffer (B1), index '2' is assigned to the second buffer (B2), and similarly, index '8' is assigned to the eighth buffer (B8). In this way, when each buffer (B) is arranged in the order in which the input pulse (P1) flows and the indices are arranged in that order, for example, 1000 buffers can each be assigned an index from 1 to 1000.

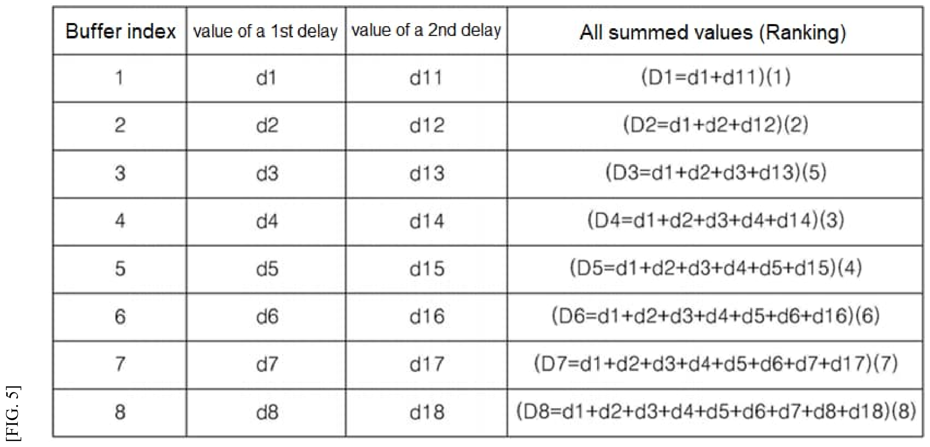

FIG. 5 is a table for explaining the data path delay considered in an embodiment of the present invention.

Referring to FIG. 1 and FIG. 5, the code conversion part (30) can convert the order of the elements (e.g., 1, 2, 3, 4, 5, 6, 7, 8) of the said thermometer code (01) (e.g., 11100000) output from the first delay line part (20) and output it. At this time, the code output by the code conversion part (30) (e.g., 11010000) (the order of the corresponding buffer indices is 1, 2, 4, 5, 3, 6, 7, 8) can be referred to as 'converted code (CO1)'.

The converted code (CO1) output by the code conversion part (30) can be one in which the order of the elements of the said thermometer code (01) is sorted based on a predetermined criterion. At this time, the said predetermined criterion can be the said data path delay from the output node (N1) of the input pulse (P1) to the respective output nodes (N2) of a plurality of flip-flops (FF) included in the first delay line part (20). This will be explained in detail with reference to FIG. 5.

Each field of the table shows the buffer index number, the value of the first delay, the value of the second delay, and the sum value (rank). At this time, the said rank can represent the rank for all sum values. Here, the buffer with the smallest sum value has the 1st rank, and the buffer with the largest sum value has the last rank. Or, in other embodiments, the opposite is also possible.

As described above in FIG. 3, the said sum value can mean the time it takes for data to be delivered from the node (N1) where the input pulse (P1) is output to an arbitrary flip-flop (e.g., FF4).

The time it takes for the input value of an arbitrary buffer to be delivered to another buffer consecutive to the said arbitrary buffer, which is the first delay, and the time it takes for the output value of the said arbitrary buffer to be delivered to the input of the flip-flop connected to the said arbitrary buffer, which is the second delay, can occur. At this time, for each buffer, the value obtained by adding the value of the first delay and the value of the second delay can be referred to as the data path delay.

Referring to FIG. 3 and FIG. 5 together, when the indices of each buffer are listed in order, the rank of the sum of the first delay value and the second delay value can be different from the rank of the index number of each buffer. For example, in the case of the 3rd buffer, the buffer arrangement rank is 3rd, so the index number is '3', but the rank of the sum value can be '5'. Looking in detail, to deliver data to the 3rd flip-flop (FF3), it passes through the 1st buffer (B1), the 2nd buffer, and the 3rd buffer. At this time, a certain delay (d1, d2, d3) occurs each time it passes through the 1st buffer (B1), the 2nd buffer (B2), and the 3rd buffer (B3), and the delay (d13) until the data output from the 3rd buffer (B3) is output as the output value of the 3rd flip-flop (FF3) also occurs. That is, the delay until data is delivered from the output node (N1) of the input pulse (P1) to the output node (N2, N23) of the 3rd flip-flop (FF3) can be the sum of d1, d2, d3, and d13.

In this way, the delay (i.e., the sum value) until data is delivered to the output node of each flip-flop (FF3) can be calculated.

For example, in this embodiment, the buffer index for the 3rd flip-flop (FF3) is 3, and the buffer index for the 4th flip-flop (FF4) is 4. That is, the 4th flip-flop (FF3) has to pass through one more buffer than the 3rd flip-flop (FF4), but nevertheless, the delay sum value to the output node of the 3rd flip-flop with buffer index 3 can be larger. The code conversion part (30) can convert the order of the elements of the said thermometer code (01) based on the calculated delay (sum value) (e.g., from the smallest sum value).

The converted code (CO1) output by the code conversion part (30) can be provided to the priority encoder part (50).

The priority encoder part (50) can digitize a long thermometer code. For example, the priority encoder part (50) can convert a 5200-bit thermometer code into a 13-bit thermometer code. For example, if the buffer (delay element) (B) and the flip-flop (FF) connected to the said buffer, as described in FIG. 3, are 5200 each, a continuous binary number sequence of 5200 is output, which can be represented by a 13-bit binary number.

That is, the priority encoder part (50), as the output value (CO1) over time from the code conversion part (30), can represent the first thermometer code (TC1) and the second thermometer code (TC2) of 5200 bits as a 13-bit binary number.

Referring to FIG. 2, the first thermometer code (TC1) may be the code output by the code conversion part (30) in relation to the rising edge of the input pulse (P1) at the time of the rising edge (E4) of the first occurring clock pulse (CK2) after the rising edge (E1) of the input pulse (P1) occurs. The first thermometer code (TC1) represented as 13 bits can be provided as input to the computation part (60).

And the second thermometer code (TC2) may be the code output by the code conversion part (30) in relation to the falling edge (E2) of the input pulse (P1) at the time of the rising edge (E6) of the first occurring clock pulse (CK4) after the falling edge (E2) of the input pulse (P1) occurs. The second thermometer code (TC2) represented as 13 bits can be provided as input to the computation part (60).

At this time, the time interval of the first thermometer code (TC1) and the time interval of the second thermometer code (TC2) may be smaller than the period of the clock pulse (CK).

Referring again to FIG. 1 and FIG. 2, the clock pulse count part (40) can receive the input pulse (P1) from the input signal generation part (10).

The clock pulse count part (40) can count the number of clock pulses (CK) that occur during the duration (T) of the input pulse (P1). For example, in FIG. 2, since the rising edges of the clock pulses that occur during the period when the input pulse (P1) is in the ON state are 2, like edges (E4, E5), the counted value can be 2. The said clock pulses can mean the pulses that constitute the clock generated inside or outside the TDC.

The output value (Coarse count) of the clock pulse count part (40), i.e., the said counted value, is provided to the computation part (60).

Referring to FIG. 1 and FIG. 2, the computation part (60) can determine the value of the said time difference of occurrence by using the said first thermometer code (TC1), the said second thermometer code (TC2), and the number of the said counted clock pulses. That is, the said time difference of occurrence can be calculated as in Equation 1.

[Equation 1]

$$T = CP * CC + TC1 - TC2$$

In Equation 1, T is the time difference of occurrence between the start signal and the stop signal, CP is the occurrence period of the clock pulses, CC is the number of clock pulses counted by the clock pulse count part (40), TC1 is the first thermometer code, and TC2 is the second thermometer code.

For example, in the example of FIG. 2, the said time difference of occurrence can be 2*Period+TC1-TC2.

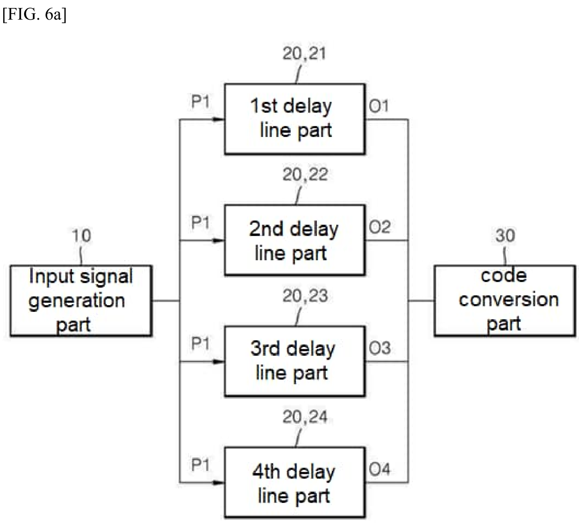

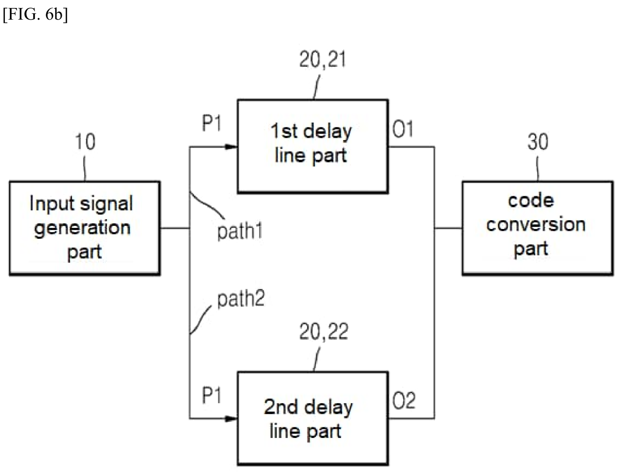

FIG. 6a and FIG. 6b show a parallel configuration of multiple delay line parts according to an embodiment of the present invention.

As in FIG. 6a, the delay line part (20) may be connected in parallel two or more times. At this time, the input pulse (P1) output from the input signal generation part (10) can be input to the first delay line part (21), the second delay line part (22), the third delay line part (23), and the fourth delay line part (24), respectively. And the first thermometer code (01), the second thermometer code (02), the third thermometer code (03), and the fourth thermometer code (04) output from the first delay line part (21), the second delay line part (22), the third delay line part (23), and the fourth delay line part (24) can be input to the code conversion part (30).

As in FIG. 6b, let's assume that in another embodiment, two delay line parts (20) are connected in parallel.

For example, the input pulse (P1) output from the input signal generation part (10) can be provided along a first path (path1) connecting the output terminal of the input signal generation part (10) and the input terminal of the first delay line part (21), and along a second path (path2) connecting the output terminal of the input signal generation part (10) and the input terminal of the second delay line part (22).

At this time, the time it takes for the input pulse (P1) output from the input signal generation part (10) to reach the input terminal of the first delay line part (21) and the input terminal of the second delay line part (22) can be different. This is because there is an input delay due to the length difference between the said first path (path1) and the said second path (path). In the embodiment of FIG. 6a, since the length of the first path (path1) is shorter than the length of the second path (path2), it can be seen that the input time interval of the input pulse (path1) is smaller than the input time interval of the input pulse (path2) through the second path (path2).

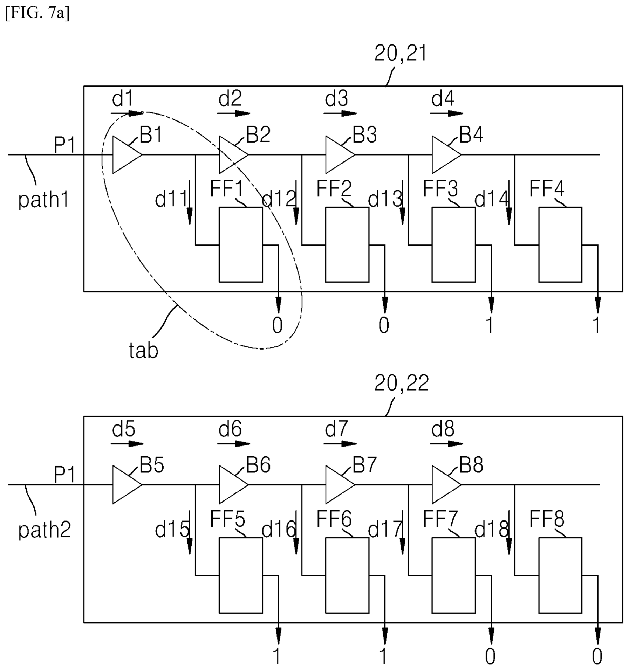

FIG. 7a shows the configuration of the first delay line part and the second delay line part of FIG. 6b.

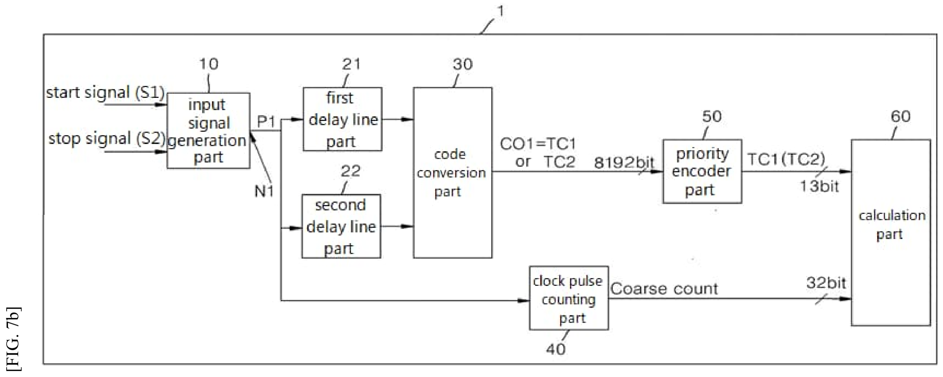

FIG. 7b shows the change in the configuration of the FPGA of FIG. 1 when a second delay line part is added in addition to the first delay line part.

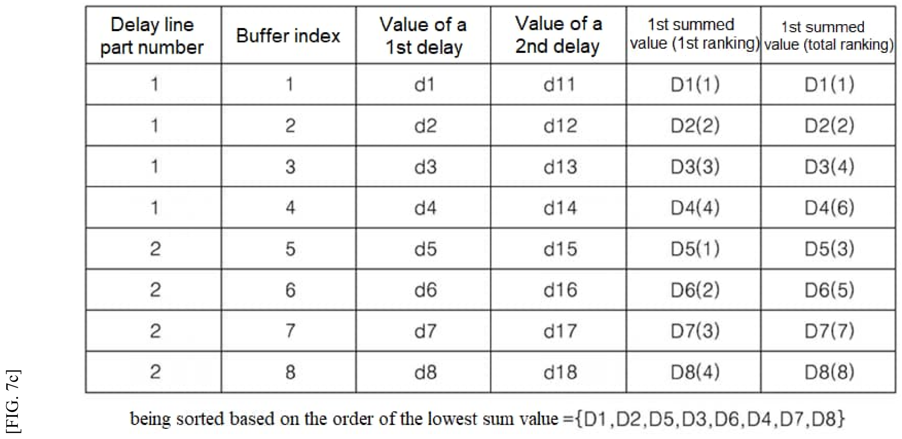

FIG. 7c is for explaining the operation of the code conversion part when two delay line parts are used according to an embodiment of the present invention.

In FIG. 7a, for convenience of explanation, it is shown that the buffers and flip-flops within each delay line part each include 4 units.

In the table of FIG. 7c, each field can represent the delay line part number, buffer index number, first delay value, second delay value, first sum value (first rank), and first sum value (overall rank). At this time, the said first rank can represent the rank for each sum value for the buffer indices of the buffers within each delay line part. And the said overall rank can represent the rank for each sum value for the buffer indices of all buffers of the first delay line part and the second delay line part. At this time, the said first rank and overall rank can have the buffer with the smallest sum value as the 1st rank, and the buffer with the largest sum value as the last rank. Or, in other embodiments, the opposite is also possible. The method for obtaining the sum value is the same as described in FIG. 5.

The code conversion part (30) is configured to generate a single converted code by sorting and merging the elements of the first set (e.g., {(D1, 1), (D2, 2), (D3, 3), (D4, 4)}), which lists the sum values and buffer index pairs of the elements of the thermometer code output by the first delay line part (21) in order of low sum value, and the elements of the second set (e.g., e.g., {(D5, 5), (D6, 6), (D7, 7), (D8, 8)}), which lists the sum values and index pairs of the elements of the thermometer code output by the second delay line part (22) in order of low sum value.

That is, each element of the said first set and each element of the said second set can be sorted based on the order of low sum value.

For example, the output values based on buffer index from the first delay line part (21) can be {1, 2, 3, 4}, and the output values based on buffer index from the second delay line part (22) can be {5, 6, 7, 8}. And in the embodiment of FIG. 6b and FIG. 7a, the delay (d1) can be smaller than the delay (d5). Therefore, the sorted order can be (D1, 1), (D2, 2), (D5, 5), (D3, 3), (D6, 6), (D4, 4), (D7, 7), (D8, 8). The output values of the flip-flops for each buffer index can be sorted in the said sorted order. For example, the sorted values (buffer index) can be 0(1), 0(2), 1(4), 1(6), 1(3), 1(5), 0(7), 0(8).

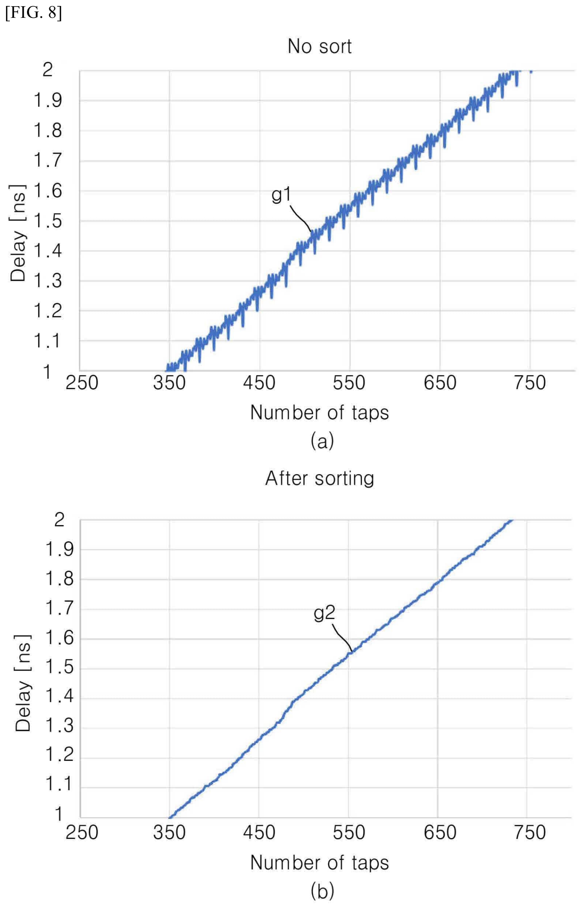

As described above, when multiple delay line parts (20) are used, they can have slightly different input delays depending on the placement. FIG. 8, which will be described below, shows the delay according to the placement when multiple delay line parts are used.

FIG. 8 is a graph of the delay according to the application of the code conversion part in an embodiment of the present invention.

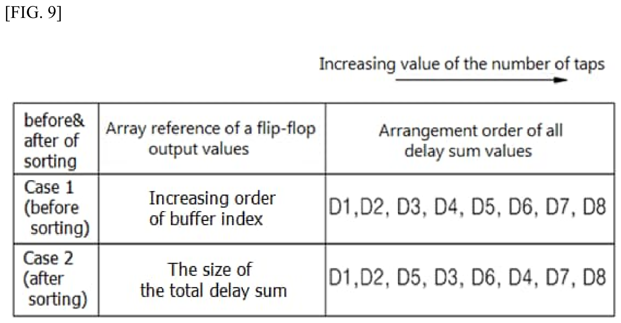

FIG. 9 is a diagram for explaining the array criterion of flip-flop output values and the increment in the number of taps in FIG. 8, depending on the application of the code conversion part, according to an embodiment of the present invention.

(a) of FIG. 8 shows the delay graph according to the number of taps in a state where the code conversion part (30) is not applied, and (b) of FIG. 8 shows the delay graph according to the number of taps in a state where the code conversion part (30) is applied.

The fields of the table in FIG. 9 include before and after sorting, the array criterion of flip-flop output values, and the array order of the total delay sum values.

Hereinafter, description will be provided with reference to FIG. 8 and FIG. 9 together. The horizontal axis of the graphs (g1, g2) represents the number of taps. Referring to FIG. 7c, one tap can mean a pair of one buffer (delay element) (e.g., B1) and a flip-flop (FF1) connected to it. For example, if the total number of pairs of buffers and flip-flops connected to them is 1000, the total number of taps can be 1000.

The vertical axis of the graphs (g1, g2) represents the delay time (ns). The said delay time can mean the sum of the delays it takes for data to be delivered to the output node of the flip-flop tapped at each buffer, as described in FIG. 5.

Referring to FIG. 7a to FIG. 9 together, the increase in the number of taps in the graph (g1) can mean, for example, an increase in the buffer index. For example, if the number of taps on the horizontal axis of the graph (g1) is 4, it can mean buffer index 4. At this time, the delay value on the vertical axis of the graph (g1) can be $D4(=d1+d2+d3+d4+d14)$ as in FIG. 7c. For example, if the number of taps is 5, it can mean buffer index 5. At this time, the delay value on the vertical axis of the graph (g1) can be $D5(=d5+d15)$. Here, referring to FIG. 9, it can be $D4>D5$. Here, it can be seen that the delay observed at each tap's flip-flop does not increase as the tap's index (e.g., index 4 -> index 5) increases, but rather, a case of local decrease also occurs.

On the other hand, the increase in the number of taps in the graph (g2) does not mean an increase in the buffer index, but rather an increase in the position according to the sorted order in the state where the output values of each flip-flop are sorted by the code conversion part (30). For example, if the number of taps on the horizontal axis of the graph (g2) is 4, the order of the position of the sorted buffer index is 1, 2, 5, 3, which can mean buffer index 3. And in this case, the delay value on the vertical axis of the graph (g2) can be $D3(=d1+d2+d3+d13)$. For example, if the number of taps is 5, the order of the position of the sorted buffer index is 1, 2, 5, 3, 6, which can mean buffer index 6. And in this case, the delay value is $D6(=d5+d6+d16)$. Here, referring to FIG. 9, it can be $D3<D6$.

That is, as in (a) of FIG. 8, when the code conversion part (30) of the present invention is not applied, it can be seen that the graph (g1) for the delay with respect to the increase in the number of taps does not exhibit a monotonically increasing property. On the other hand, as in (b) of FIG. 8, when the code conversion part (30) of the present invention is applied, it can be seen that the graph (g2) for the delay with respect to the increase in the number of taps exhibits a non-decreasing increasing phenomenon.

For example, unlike custom semiconductor ASICs, FPGAs, which can be directly designed through programming, can change the function of the chip according to the programming. Therefore, unlike ASICs, the function of each component included in an FPGA can differ (or depending on the placement of the components), so the delay does not always increase as the number of taps increases, and cases of decrease can also exist, so a non-decreasing increasing phenomenon may not be achieved.

However, as explained, through the graph (g2), it can be confirmed that the code conversion part (30) can correct the monotonically increasing property of the first delay line part (20).

As described above, when multiple delay line parts (20) are used, the code conversion part can provide sorting of the delay. As a result, it is possible to provide a TDC with high time resolution by correcting for errors due to jitter. For example, when four delay line parts are configured in parallel to have a total of 9600 taps, a TDC with a resolution of 0.8 ps per tap can be provided.

<Configuration for tagging the occurrence time of a single event>

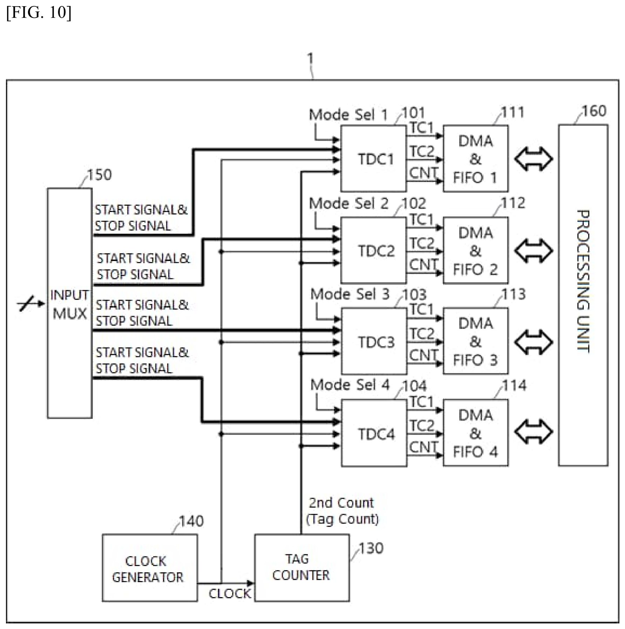

FIG. 10 shows the configuration of an FPGA provided according to a preferred embodiment of the present invention.

The configuration of the FPGA (1) shown in FIG. 10 can be implemented by a binary file containing configuration data for programming the FPGA (1) to implement a digital circuit having the configuration of FIG. 10.

The FPGA (1) shown in FIG. 10 may include one or more TDCs. A TDC can be represented by reference number 100, and different TDCs can be represented as TDCx (ex: TDC1(101), TDC2(102), TDC3(103), TDC4(104), ...).

The said one or more TDCs can have the same internal configuration, i.e., they can all operate in the same way.

The FPGA (1) may include an input multiplexer (150) that provides a start signal and a stop signal to each TDC (100). The input multiplexer (150) can receive event pulses representing the event that the FPGA (1) wants to detect, and can output the said event pulses as the said start signal or stop signal for each TDC (100) according to a predetermined rule.

The FPGA (1) may include a tag counter (130).

The FPGA (1) may include a clock generator (140). Some or all of the said TDCs (100) included in the FPGA (1), and the tag counter (130), can receive the clock generated by the clock generator (140). Therefore, the clock generated by the TDC (100) can also be referred to as a common clock.

The tag counter (130) can provide the second count, which is the result of counting the number of occurrences of the said input clock, to some or all of the said TDCs (100) included in the FPGA (1). The said second count can also be called a 'tag count' or a 'global count'.

Each TDC (100) can be configured to operate in one of two modes. The mode selection signal that determines the operating mode of each TDC (100) is indicated by the symbol 'Mode Sel' in FIG. 10. The operating mode of each TDC (100) can be determined by a device external to the corresponding TDC (100). The said two modes will be described in more detail in the latter part of this specification.

As described above, each TDC (100) can receive the start signal and stop signal provided by the input multiplexer (150), the clock provided by the clock generator (140), and the second count provided by the tag counter (130).

Each TDC (100) can output three output signals, which are denoted as TC1, TC2, and CNT in FIG. 10. The meaning of these three symbols will be explained in more detail in the latter part of this specification.

The FPGA (1) may include one or more DMA units. A DMA unit can be represented by reference number 110, and different DMAs can be represented as DMAx (ex: DMA1(111), DMA2(112), DMA3(113), DMA4(114), ...). DMAx corresponds to TDCx.

The said three output signals output by each TDC (100) are provided to the corresponding DMA (110).

The input signal generation part (10) may further include a processing unit (160). The processing unit (160) can receive the signals output by the TDC (100) from the DMA (110) and process them according to a predetermined algorithm.

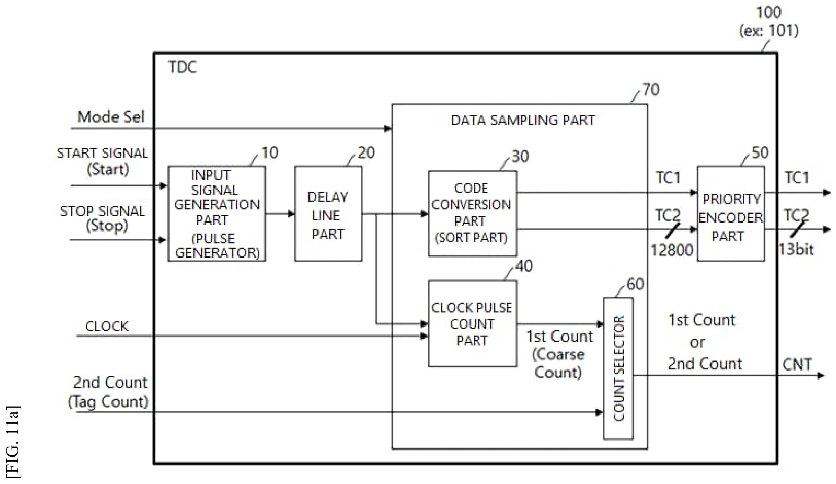

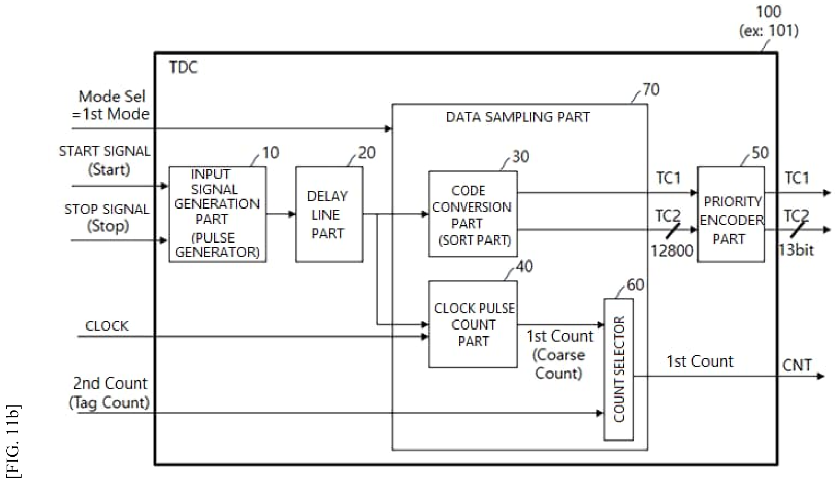

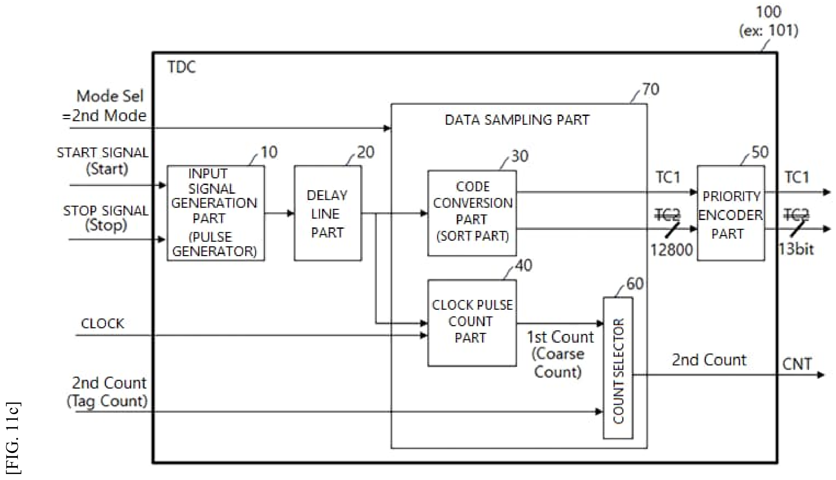

FIG. 11 shows the configuration and operation method of any one of the multiple TDCs presented in FIG. 10.

The TDC (100) may include an input signal generation part (10), a delay line part (20), a data sampling part (70), and a priority encoder part (50).

The data sampling part (70) may include a code conversion part (30), a clock pulse count part (40), and a count selection part (60).

The count selection part (60) can receive the first count output by the clock pulse count part (40) and the second count output by the tag counter (130) of FIG. 10. The count selection part (60) can be configured to select and output one of the said first count and the said second count to the TDC (100) according to the said mode selection signal (Model Sel) input.

The configuration and function of the input signal generation part (10), the delay line part (20), the code conversion part (30), the clock pulse count part (40), and the priority encoder part (50) are the same as those of the components having the same reference numbers presented in FIG. 1 and FIG. 7b, so the above description will be substituted.

FIG. 11b shows the case where the TDC of FIG. 11a operates in the first mode, and FIG. 11c shows the case where the TDC of FIG. 11a operates in the second mode. Hereinafter, description will be provided with reference to FIG. 11b.

Hereinafter, the case where the said mode selection signal (Model Sel) has a value indicating the first mode will be described. At this time, the input multiplexer (150) of FIG. 10 can provide the said start signal and stop signal to the TDC (100). And at this time, the count selection part (60) can be configured to select and output the said first count output by the tag counter (130). At this time, the code conversion part (30) can output the first thermometer code (TC1) corresponding to the said start signal and the second thermometer code (TC2) corresponding to the said stop signal. As a result, the TDC (100) can output the first thermometer code (TC1), the second thermometer code (TC2), and the first count (CNT).

Hereinafter, description will be provided with reference to FIG. 11c.

Hereinafter, the case where the said mode selection signal (Model Sel) has a value indicating the second mode will be described. At this time, the input multiplexer (150) of FIG. 10 can provide the said start signal to the TDC (100). And at this time, the count selection part (60) can be configured to select and output the said second count output by the tag counter (130). At this time, it is not necessarily prohibited for the input multiplexer (150) of FIG. 10 to provide the said stop signal to the TDC (100), but in a preferred embodiment, the input multiplexer (150) may not provide the said stop signal to the TDC (100). If the input multiplexer (150) does not provide the said stop signal to the TDC (100), the code conversion part (30) may not output the second thermometer code (TC2). However, even in this case, since the input multiplexer (150) provides the start signal to the TDC (100), the code conversion part (30) outputs the first thermometer code (TC1). As a result, the TDC (100) can output the first thermometer code (TC1) and the second count (CNT).

As shown in FIG. 10, each DMA (110) can provide the signals output from the corresponding TDC (100) to the processing unit (160).

When an arbitrary DMA (110) is connected to a TDC (100) operating in the said first mode, the said arbitrary DMA (110) can deliver the first thermometer code (TC1), the second thermometer code (TC2), and the first count (CNT) output by the said TDC (100) to the processing unit (160).

On the other hand, when an arbitrary DMA (110) is connected to a TDC (100) operating in the said second mode, the said arbitrary DMA (110) can deliver the first thermometer code (TC1) and the second count (CNT) output by the said TDC (100) to the processing unit (160).

The processing unit (160) can determine the time difference of occurrence between two consecutive events associated with an arbitrary DMA (110) or determine the occurrence time of a single event associated with the said arbitrary DMA (110), using the information provided from the arbitrary DMA (110).

The processing unit (160) can be configured to know whether the TDC (100) connected to an arbitrary DMA (110) operated in the said first mode or in the said second mode. In one embodiment, the entity that determines the value of the said mode selection signal (Model Sel) input to the said TDC (100) can be another functional unit not shown in FIG. 10, and in this case, the value of the said mode selection signal (Model Sel) input to the said TDC (100) can be provided to the processing unit (160).

In another embodiment, the entity that determines the value of the said mode selection signal (Model Sel) may be the said processing unit (160).

When the TDC (100) connected to the said arbitrary DMA (110) has operated in the said first mode, the processing unit (160) can determine the time difference of occurrence between two consecutive events associated with the said arbitrary DMA (110). That is, the processing unit (160) can execute the function of the computation part (60) of FIG. 1. The occurrence times of the said two events can be specified by the start signal and stop signal input to the said TDC (100), respectively.

When the TDC (100) connected to the said arbitrary DMA (110) has operated in the said second mode, the processing unit (160) can determine the occurrence time of a single consecutive event associated with the said arbitrary DMA (110). Here, the occurrence time of the said single event can be specified by the start signal input to the said TDC (100). At this time, the processing unit (160) knows that the said TDC (100) is operating in the said second mode, and therefore can ignore the information regarding the stop signal that may or may not be input to the said TDC (100) without waiting for it. That is, the processing unit (160) can execute a predetermined routine regardless of the occurrence of the second thermometer code (TC2) that the TDC (100) operating in the second mode may output.

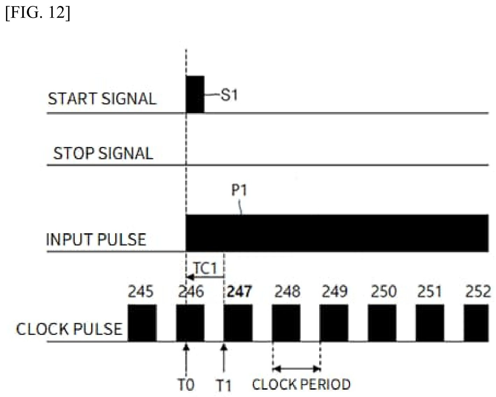

The processing method of the processing unit (160) for the data provided by the TDC (100) operating in the said first mode is shown in the aforementioned Equation 1 and FIG. 2. Now, the processing method of the processing unit (160) for the data provided by the TDC (100) operating in the said second mode will be described using Equation 2 and FIG. 12.

[Equation 2]

$$T0 = CP * TC - TC1$$

In Equation 2, T0 is the occurrence time of the start signal, CP is the occurrence period of the clock pulses, TC is the number of occurrences of the clock pulses counted by the tag counter (130) of FIG. 10, and TC1 is the first thermometer code.

FIG. 12 is a diagram for explaining the input pulse input to the delay line part according to an embodiment of the present invention.

As in FIG. 12, the input signal generation part (10) can generate an input pulse (P1) starting from the rising edge of a given start signal (S1). That is, the rising edge of the input pulse (P1) occurs at the rising edge of the start signal (S1).

The operating principle of the input signal generation part (10) presented in FIG. 11a is the same as that of the one presented in FIG. 1, so if a stop signal is provided to the input signal generation part (10), a falling edge of the said input pulse (P1) can occur, and the said input pulse (P1) can be extinguished. However, FIG. 12 presents an example where the said stop signal is not provided to the input signal generation part (10), so the falling edge of the said input pulse (P1) has not occurred.

If the said stop signal does not occur, the said input pulse (P1) may persist semi-permanently. To extinguish the input pulse (P1), the processing unit (160) can reset the TDC (100) that operated in the said second mode after processing all the data provided by the TDC (100) that operated in the said second mode according to a predetermined algorithm. By doing so, the input pulse (P1) that the input signal generation part (10) was outputting can be extinguished. The said input pulse (P1) can also be extinguished according to a different design method from the aforementioned configuration. For example, the processing unit (160) can provide a dummy pulse, which is not the measurement target, as the said stop signal to the TDC (100) that operated in the said second mode at an appropriate time.

In one embodiment, the TC of the said Equation 2 may be the occurrence order (ex: 247) of the clock pulse first input to the tag counter (130) after the rising edge of the said input pulse occurs. The TC of the said Equation 2 is the same as the second count shown in FIG. 10.

And the TC1 of the said Equation 2 can be the first thermometer code (TC1) output by the said code conversion part (30) at the rising edge time of the said first input clock pulse.

The processing unit (160) can determine the occurrence time of the start signal input to the TDC (100) that operated in the said second mode by applying the said second count (TC), the said first thermometer code (TC1), and the clock period (CP) of the clock output by the clock generator (140) to Equation 2.

The multiple TDCs presented in FIG. 10 can each operate independently. To help understanding, the following example is presented.

That is, two signals selected by the input multiplexer (150) can be provided as the start signal and stop signal for the first TDC (101), respectively. At this time, the mode selection signal (Model Sel 1) input to the first TDC (101) can have a value indicating the said first mode, and the processing unit (160) can analyze the data output by the first TDC (101) to calculate the time difference of occurrence between the said two signals. Simultaneously with or at a time-shifted state from providing the said start signal or the said stop signal for the first TDC (101), the input multiplexer (150) can provide a second start signal for the second TDC (102) to the second TDC (102). At this time, the mode selection signal (Model Sel 2) input to the second TDC (102) can have a value indicating the said second mode, and the processing unit (160) can analyze the data output by the second TDC (102) to determine the occurrence time of the said second start signal.

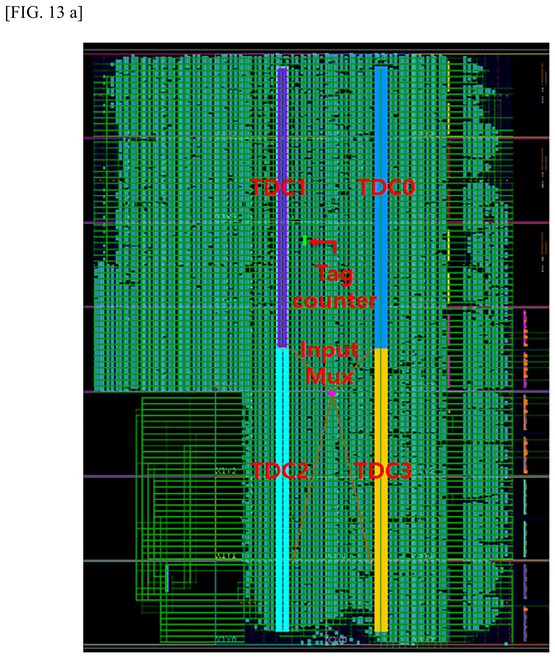

FIG. 13a shows the relative positions of the multiple TDCs, the tag counter, and the input multiplexer presented in FIG. 10 on the surface of the actual circuit implemented on an FPGA, according to an embodiment of the present invention.

The values related to the occurrence time of the said start signal or stop signal measured by each TDC can have large errors depending on the length of the line through which the said start signal or stop signal moves. Therefore, the locations where the said start signal or stop signal are provided need to be optimized.

Also, in the process of determining the occurrence time of the said start signal measured by each TDC in the said second mode, the clock provided in common to the said multiple TDCs by the clock generator (140) is involved. If the variation in the arrival time of the clock generated by the clock generator (140) at the input terminals of different TDCs (100) is large, there is a problem that a time axis bias is included in the values related to the occurrence time calculated by each of the said multiple TDCs. The variation in the arrival time of the said clock at the input terminals of different TDCs (100) can be proportional to the distance between the clock generator (140) and the input terminals of the said different TDCs (100). Therefore, the design should be such that the variation among the distances between the clock generator (140) and the input terminals of the said different TDCs (100) is small.

For this purpose, as shown in FIG. 13a, an embodiment of the present invention is characterized in that it is placed inside the area enclosed by the multiple TDCs.

Each TDC includes a delay line part (20), and in an embodiment of the present invention, the delay line part (20) has a shape that is elongated in one direction on the actual circuit plane of the FPGA. Therefore, one TDC has a shape that is elongated in one direction.

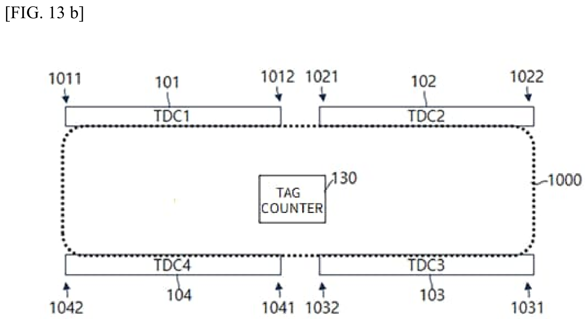

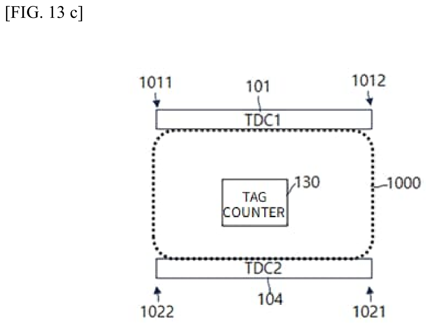

FIG. 13b and FIG. 13c conceptually represent the features of the present invention presented in FIG. 13a.

Each TDC formed on the FPGA (1) has an elongated shape in one direction, and both ends can be defined along the extension direction of each TDC. For example, in FIG. 13b, the both ends of the first TDC (101) are shown with reference numbers 1011, 1012, the both ends of the second TDC (102) are shown with reference numbers 1021, 1022, the both ends of the third TDC (103) are shown with reference numbers 1031, 1032, and the both ends of the fourth TDC (104) are shown with reference numbers 1041, 1042.

FIG. 13c shows the case where there are only 2 TDCs that receive the common clock provided by the clock generator (140) of FIG. 10.

As illustrated in FIG. 13b and FIG. 13c, in a preferred embodiment of the present invention, the tag counter (130) is characterized by being placed inside an area (1000) that can be formed by connecting the both ends of the said multiple TDCs. The configuration data for programming the said FPGA (1) may include data for placing the tag counter (130) inside the said area (1000).

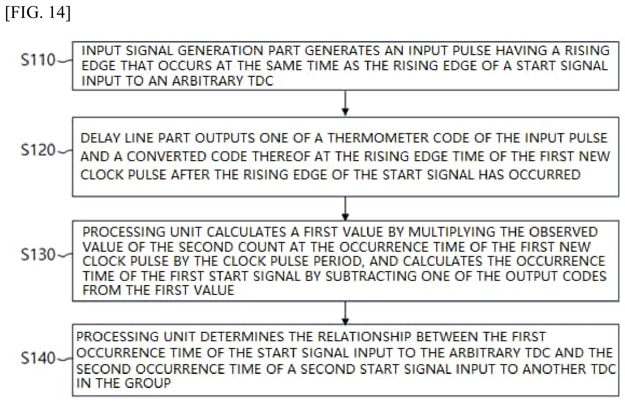

FIG. 14 is a flowchart showing a method for calculating the occurrence time of an input predetermined signal, provided according to an embodiment of the present invention. The method presented in FIG. 14 can be executed on a certain electronic device. In a preferred embodiment, the said electronic device may be an FPGA, but the said electronic device is not limited to an FPGA.

The said electronic device may include a group of TDCs with identical configurations, a clock generator for providing a clock in common to the said group of TDCs, a tag counter configured to generate a second count, which is the counted value of the said clock, and provide it in common to the said group of TDCs, and a processing unit. And each of the said TDCs may include an input signal generation part and a delay line part. The said signal occurrence time calculation method may include the following steps (S110), (S120), and (S130).

In step (S110), the input signal generation part of an arbitrary TDC among the said group of TDCs can generate an input pulse having a rising edge that occurs at the same time as the rising edge of a start signal input to the said arbitrary TDC.

In step (S120), the delay line part of the said arbitrary TDC can output one of a thermometer code of the said input pulse and a converted code obtained by converting the said thermometer code, at the rising edge time of the first newly generated clock pulse of the said clock after the rising edge of the said start signal has occurred.

In step (S130), the said processing unit calculates a first value by multiplying the value of the said second count observed at the occurrence time of the said first newly generated clock pulse of the said clock by the pulse period of the said clock, and then can calculate the occurrence time of the said first start signal by subtracting one of the said output codes from the said first value.

An embodiment of the present invention may further include the following step (S140) after the aforementioned step (S130).

In step (S140), the said processing unit can determine the relationship between a first occurrence time, which is the occurrence time of the said start signal input to the said arbitrary TDC among the said group of TDCs, and a second occurrence time, which is the occurrence time of a second start signal input to another TDC among the said group of TDCs. For example, it can determine the difference between the said first occurrence time and the said second occurrence time. At this time, to determine the said second occurrence time, the said steps (S110), (S120), and (S130) can be executed independently and separately for the said second start signal.

In this case, the said arbitrary TDC can be configured to operate in either a first mode or a second mode.

In this case, the said arbitrary TDC is configured to generate the said input pulse in both the said first mode and the said second mode, and the said arbitrary TDC can be configured to receive a stop signal in the said first mode.

In this case, when the said stop signal is input to the said arbitrary TDC, the said input signal generation part can be configured to generate the said input pulse such that its width is equal to the time difference between the rising edge of the said start signal and the rising edge of the said stop signal.

In this case, the said processing unit is configured to calculate the time difference of occurrence between the said start signal and the said stop signal using one of the said codes output by the delay line part of the said arbitrary TDC at the rising edge time of the said first newly generated clock pulse when the said arbitrary TDC operates in the said first mode, and conversely, is configured to calculate the occurrence time of the said start signal when the said arbitrary TDC operates in the said second mode.

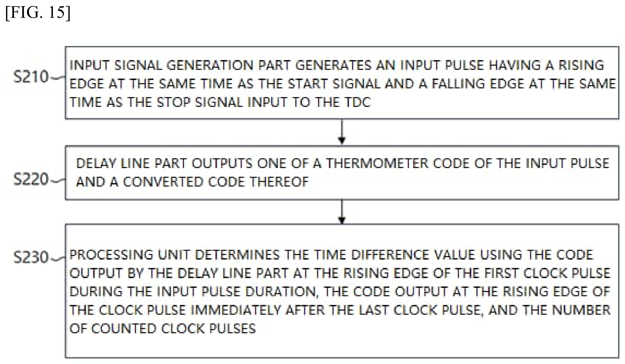

FIG. 15 is a flowchart showing a method for calculating the time difference of occurrence between an input predetermined start signal and stop signal, provided according to an embodiment of the present invention.

The method presented in FIG. 15 can be executed on a certain electronic device. In a preferred embodiment, the said electronic device may be an FPGA, but the said electronic device is not limited to an FPGA.

The said electronic device may include a group of TDCs with identical configurations, a clock generator for providing a clock in common to the said group of TDCs, a tag counter configured to generate a second count, which is the counted value of the said clock, and provide it in common to the said group of TDCs, and a processing unit. And each of the said TDCs may include an input signal generation part and a delay line part.

The method for calculating the time difference of occurrence between the said start signal and stop signal may include the following steps (S210), (S220), and (S230).

In step (S210), the input signal generation part of an arbitrary TDC among the said group of TDCs can generate an input pulse having a rising edge that occurs at the same time as the rising edge of the start signal input to the said arbitrary TDC, and a falling edge that occurs at the same time as the stop signal input to the said arbitrary TDC.

In step (S220), the delay line part of the said arbitrary TDC can output one of a thermometer code of the said input pulse and a converted code obtained by converting the said thermometer code.

In step (S230), the said processing unit can determine the value of the said time difference of occurrence by using one of the said codes output by the said delay line part at the rising edge time of the first clock pulse among the clock pulses generated during the duration of the said input pulse, one of the said codes output by the said delay line part at the rising edge time of the clock pulse occurring immediately after the last clock pulse among the clock pulses generated during the duration of the said input pulse, and the number of clock pulses counted by the clock pulse count part.

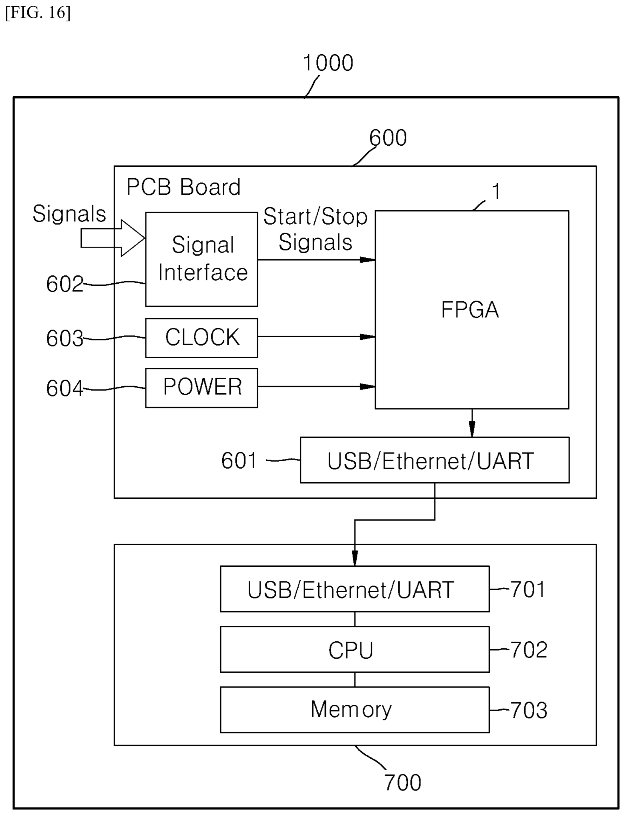

FIG. 16 is a block diagram of a TDC system provided according to an embodiment of the present invention.

The TDC system (1000) may include a PCB board (600) and a computing device (700). The PCB board (600) is a device capable of digital signal processing and may include the aforementioned FPGA (1), a data interface (601), a signal interface (602), a clock generator (603), and a power supply unit (604).

The data interface (601) is a device that enables data exchange between the PCB board (600) and the computing device (700), and can be composed of USB, Ethernet, or UART, but is not limited to these.

The signal interface (602) has a function of receiving signals for which the time difference is to be measured from the outside and delivering them to the said FPGA (1), using the said FPAG (1).

The clock generator (603) can provide a train of clock pulses for the said FPGA (1) to count.

The time difference value of two selected signals, calculated by the said FPGA (1), can be output from the FPGA (1) and provided to the data interface (601). The data interface (601) can provide the time difference value of the said two signals to the computing device (700).

The power supply unit (104) supplies the power used by the PCB board (600).

The computing device (700) may include a data interface (701), a CPU (702), and a memory (703).

The computing device (700) can be configured to execute a predetermined algorithm planned in advance, using the time difference value of two selected signals received from the PCB board (600). The time difference value of the said two received signals can be processed by a process executed in the CPU (702). The program composed of instructions for executing the said process can be stored in the memory (703). The said program can be loaded from the memory (703) to the CPU (702) and executed. The said memory (703) may be a non-volatile memory.

Using the embodiments of the present invention described above, those skilled in the technical field of the present invention can easily implement various changes and modifications within a scope that does not deviate from the essential characteristics of the present invention. The content of each claim of the patent claims can be combined with other claims that do not have a citation relationship within the scope understandable through this specification.

**Claims**

1. An FPGA, comprising:

   a group of TDCs (100) having an identical configuration;
   a clock generator (140) for generating a clock and providing said generated clock in common to said group of TDCs;
   a tag counter (130) configured to generate a second count, which is a counted value of said clock, and to provide said generated second count in common to said group of TDCs; and
   a processing unit (160);
   wherein a first TDC among said group of TDCs comprises:

      an input signal generation part (10) for generating a first input pulse (P1) having a rising edge that occurs at the same time as a rising edge of a first start signal (S1) input to said first TDC; and a delay line part (20) into which said generated first input pulse is input;
      and wherein said processing unit is configured to:

         calculate a first value by multiplying the value of said second count (TC) observed at the occurrence time of the first newly generated clock pulse of said clock after the rising edge of said first start signal input to said first TDC has occurred, by the pulse period (CP) of said clock; and
         calculate the occurrence time of said first start signal by subtracting, from said first value, a thermometer code output by the delay line part of said first TDC or a converted code obtained by converting said thermometer code at the rising edge time of said first newly generated clock pulse.

2. The FPGA of claim 1, wherein

   said first TDC is configured to operate in one of a first mode and a second mode,
   said first TDC is configured to generate said first input pulse in both said first mode and

said second mode, and said first TDC is configured to receive a first stop signal in said first mode,
when said first stop signal is input to said first TDC, said input signal generation part is configured to generate said first input pulse such that its width is equal to the time difference between the rising edge of said first start signal and the rising edge of said first stop signal, and
said processing unit is configured to calculate the time difference of occurrence between said first start signal and said first stop signal using the thermometer code output by the delay line part of said first TDC at the rising edge time of said first newly generated clock pulse when said first TDC operates in said first mode, and is configured to calculate the occurrence time of said first start signal when said first TDC operates in said second mode.

3. The FPGA of claim 2, wherein

   said first TDC further comprises a clock pulse count part (40) for counting the number of clock pulses of said clock generated during the duration of said first input pulse, and
   when said first TDC operates in said first mode, said processing unit is configured to determine the value of said time difference of occurrence by using the thermometer code output by said delay line part at the rising edge time of the first clock pulse among the clock pulses generated during the duration of said first input pulse, the thermometer code output by said delay line part at the rising edge time of the clock pulse occurring immediately after the last clock pulse among the clock pulses generated during the duration of said first input pulse, and the number of clock pulses counted by said clock pulse count part.

4. The FPGA of claim 2, wherein

   said first TDC further comprises: a code conversion part (30) for outputting a converted code generated by converting the order of the elements of the thermometer code output by said delay line part; and a clock pulse count part (40) for counting the number of clock pulses of said clock generated during the duration of said first input pulse, and
   when said first TDC operates in said first mode, said processing unit is configured to determine the value of said time difference of occurrence by using a first thermometer code output by said code conversion part at the rising edge time of the first clock pulse among the clock pulses generated during the duration of said first input pulse, a second thermometer code output by said code conversion part at the rising edge time of the clock pulse occurring immediately after the last clock pulse among the clock pulses generated during the duration of said first input pulse, and the number of clock pulses counted by said clock pulse count part.

5. The FPGA of claim 4, wherein

said converted code is one in which the order of the elements of the thermometer code output by said delay line part is sorted according to a predetermined criterion, and said predetermined criterion is the data path delay from the output node of said first input pulse to the respective output nodes of a plurality of flip-flops (FF) included in said delay line part.

6. The FPGA of claim 1, wherein

said processing unit is configured to determine a relationship between a first occurrence time, which is the occurrence time of said first start signal input to said first TDC among said group of TDCs, and a second occurrence time, which is the occurrence time of a second start signal input to a second TDC among said group of TDCs, and on a circuit plane of said FPGA, said tag counter is **characterized by** being placed inside an area (1000) that interconnects the regions occupied by said group of TDCs.

7. The FPGA of claim 2, wherein said first TDC further comprises:

a clock pulse count part (40) for outputting a first count, which is a result value of counting the number of clock pulses of said clock generated during the duration of said first input pulse; and a count selection part (60) configured to select and output said first count among said first count and said second count in said first mode, and to select and output said second count among said first count and said second count in said second mode.

8. The FPGA of claim 2, wherein

when said first stop signal is not input to said first TDC operating in said first mode, said processing unit is configured to extinguish said first input pulse upon completion of the calculation of the occurrence time of said first start signal.

9. A non-volatile recording medium storing program instructions executable on an electronic device,

wherein said electronic device comprises a group of TDCs with an identical configuration, a clock generator for providing a clock in common to said group of TDCs, a tag counter configured to generate a second count, which is a counted value of said clock, and to provide it in common to said group of TDCs, and a processing unit, and each of said TDCs comprises an input signal generation part and a delay line part, and when said program instructions are executed on said electronic device, the following steps are performed:

a step where the input signal generation part of an arbitrary TDC among said group of TDCs generates an input pulse having a rising edge that occurs at the same time as a rising edge of a start signal input to said arbitrary TDC; a step where the delay line part of said arbitrary TDC outputs one of a thermometer code of said input pulse and a converted code obtained by converting said thermometer code, at the rising edge time of the first newly generated clock pulse of said clock after the rising edge of said start signal has occurred; and a step where said processing unit calculates a first value by multiplying the value of said second count observed at the occurrence time of said first newly generated clock pulse of said clock by the pulse period of said clock, and then calculates the occurrence time of said first start signal by subtracting one of said output codes from said first value; which is **characterized by** being executed.

10. The non-volatile recording medium of claim 9, wherein, when said program instructions are executed on said electronic device,

said arbitrary TDC is configured to operate in one of a first mode and a second mode, said arbitrary TDC is configured to generate said input pulse in both said first mode and said second mode, and said arbitrary TDC is configured to receive a stop signal in said first mode, when said stop signal is input to said arbitrary TDC, said input signal generation part is configured to generate said input pulse such that its width is equal to the time difference between the rising edge of said start signal and the rising edge of said stop signal, and
said processing unit is configured to calculate the time difference of occurrence between said start signal and said stop signal using one of said codes output by the delay line part of said arbitrary TDC at the rising edge time of said first newly generated clock pulse when said arbitrary TDC operates in said first mode, and is configured to calculate the occurrence time of said start signal when said arbitrary TDC operates in said second mode.

11. The non-volatile recording medium of claim 10, wherein

each of said TDCs further comprises a clock pulse count part for counting the number of clock pulses of said clock generated during the duration of said input pulse, and
when said program instructions are executed on said electronic device,
when said arbitrary TDC operates in said first mode, said processing unit is configured to execute a step of determining the value of said time difference of occurrence by using one of said codes output by said delay line part at the rising edge time of the first clock pulse among the clock pulses generated during the duration of said input pulse, one of said codes output by said delay line part at the rising edge time of the clock pulse occurring immediately after the last clock pulse among the clock pulses generated during the duration of said input pulse, and the number of clock pulses counted by said clock pulse count part.

12. The non-volatile recording medium of claim 9, wherein

each of said TDCs further comprises: a code conversion part for outputting a converted code generated by converting the order of the elements of the thermometer code output by said delay line part; and a clock pulse count part for counting the number of clock pulses of said clock generated during the duration of said input pulse, and
when said program instructions are executed on said electronic device,
when said arbitrary TDC operates in said first mode, said processing unit is configured to further execute a step of determining the value of said time difference of occurrence by using a first thermometer code output by said code conversion part at the rising edge time of the first clock pulse among the clock pulses generated during the duration of said input pulse, a second thermometer code output by said code conversion part at the rising edge time of the clock pulse occurring immediately after the last clock pulse among the clock pulses generated during the duration of said input pulse, and the number of clock pulses counted by said clock pulse count part.

13. The non-volatile recording medium of claim 9, wherein, when said program instructions are executed on said electronic device, said processing unit is configured to further execute a step of determining a relationship between a first occurrence time, which is the occurrence time of said start signal input to said arbitrary TDC among said group of TDCs, and a second occurrence time, which is the occurrence time of a second start signal input to another TDC among said group of TDCs, and
on a circuit plane of said FPGA, said tag counter is **characterized by** being placed inside the regions occupied by said group of TDCs, which are interconnected.

14. The non-volatile recording medium of claim 9, **characterized in that** said electronic device is an FPGA.

15. A TDC system comprising:

a PCB board (100) including the FPGA (1) of any one of claims 1 to 8; and
a computing device (200) for acquiring said time difference of occurrence from said PCB board.

[FIG. 1]

[FIG. 2]

[FIG. 3]

[FIG. 4]

| Buffer name | Index | Output value |
|---|---|---|
| 1st buffer (B1) | 1 | 1 |
| 2nd buffer (B2) | 2 | 1 |
| 3rd buffer (B3) | 3 | 1 |
| 4th buffer (B4) | 4 | 0 |
| 5th buffer (B5) | 5 | 0 |
| 6th buffer (B6) | 6 | 0 |
| 7th buffer (B7) | 7 | 0 |
| 8th buffer (B8) | 8 | 0 |

[FIG. 5]

| Buffer index | value of a 1st delay | value of a 2nd delay | All summed values (Ranking) |
|:---:|:---:|:---:|:---:|
| 1 | d1 | d11 | (D1=d1+d11)(1) |
| 2 | d2 | d12 | (D2=d1+d2+d12)(2) |
| 3 | d3 | d13 | (D3=d1+d2+d3+d13)(5) |
| 4 | d4 | d14 | (D4=d1+d2+d3+d4+d14)(3) |
| 5 | d5 | d15 | (D5=d1+d2+d3+d4+d5+d15)(4) |
| 6 | d6 | d16 | (D6=d1+d2+d3+d4+d5+d6+d16)(6) |
| 7 | d7 | d17 | (D7=d1+d2+d3+d4+d5+d6+d7+d17)(7) |
| 8 | d8 | d18 | (D8=d1+d2+d3+d4+d5+d6+d7+d8+d18)(8) |

[FIG. 6a]

[FIG. 6b]

EP 4 730 052 A1

[FIG. 7a]

26

[FIG. 7b]

[FIG. 7c]

| Delay line part number | Buffer index | Value of a 1st delay | Value of a 2nd delay | 1st summed value (1st ranking) | 1st summed value (total ranking) |
|---|---|---|---|---|---|
| 1 | 1 | d1 | d11 | D1(1) | D1(1) |
| 1 | 2 | d2 | d12 | D2(2) | D2(2) |
| 1 | 3 | d3 | d13 | D3(3) | D3(4) |
| 1 | 4 | d4 | d14 | D4(4) | D4(6) |
| 2 | 5 | d5 | d15 | D5(1) | D5(3) |
| 2 | 6 | d6 | d16 | D6(2) | D6(5) |
| 2 | 7 | d7 | d17 | D7(3) | D7(7) |
| 2 | 8 | d8 | d18 | D8(4) | D8(8) |

being sorted based on the order of the lowest sum value ={D1,D2,D5,D3,D6,D4,D7,D8}

[FIG. 8]

No sort

(a)

After sorting

(b)

[FIG. 9]

Increasing value of the number of taps
→

| before & after of sorting | Array reference of a flip-flop output values | Arrangement order of all delay sum values |
|---|---|---|
| Case 1 (before sorting) | Increasing order of buffer index | D1, D2, D3, D4, D5, D6, D7, D8 |
| Case 2 (after sorting) | The size of the total delay sum | D1, D2, D5, D3, D6, D4, D7, D8 |

[FIG. 10]

[FIG. 11a]

[FIG. 11b]

[FIG. 11c]

[FIG. 12]

[FIG. 13 a]

[FIG. 13 b]

[FIG. 13 c]

[FIG. 14]

| | |
|---|---|
| S110 | INPUT SIGNAL GENERATION PART GENERATES AN INPUT PULSE HAVING A RISING EDGE THAT OCCURS AT THE SAME TIME AS THE RISING EDGE OF A START SIGNAL INPUT TO AN ARBITRARY TDC |
| S120 | DELAY LINE PART OUTPUTS ONE OF A THERMOMETER CODE OF THE INPUT PULSE AND A CONVERTED CODE THEREOF AT THE RISING EDGE TIME OF THE FIRST NEW CLOCK PULSE AFTER THE RISING EDGE OF THE START SIGNAL HAS OCCURRED |
| S130 | PROCESSING UNIT CALCULATES A FIRST VALUE BY MULTIPLYING THE OBSERVED VALUE OF THE SECOND COUNT AT THE OCCURRENCE TIME OF THE FIRST NEW CLOCK PULSE BY THE CLOCK PULSE PERIOD, AND CALCULATES THE OCCURRENCE TIME OF THE FIRST START SIGNAL BY SUBTRACTING ONE OF THE OUTPUT CODES FROM THE FIRST VALUE |
| S140 | PROCESSING UNIT DETERMINES THE RELATIONSHIP BETWEEN THE FIRST OCCURRENCE TIME OF THE START SIGNAL INPUT TO THE ARBITRARY TDC AND THE SECOND OCCURRENCE TIME OF A SECOND START SIGNAL INPUT TO ANOTHER TDC IN THE GROUP |

[FIG. 15]

S210 — INPUT SIGNAL GENERATION PART GENERATES AN INPUT PULSE HAVING A RISING EDGE AT THE SAME TIME AS THE START SIGNAL AND A FALLING EDGE AT THE SAME TIME AS THE STOP SIGNAL INPUT TO THE TDC

S220 — DELAY LINE PART OUTPUTS ONE OF A THERMOMETER CODE OF THE INPUT PULSE AND A CONVERTED CODE THEREOF

S230 — PROCESSING UNIT DETERMINES THE TIME DIFFERENCE VALUE USING THE CODE OUTPUT BY THE DELAY LINE PART AT THE RISING EDGE OF THE FIRST CLOCK PULSE DURING THE INPUT PULSE DURATION, THE CODE OUTPUT AT THE RISING EDGE OF THE CLOCK PULSE IMMEDIATELY AFTER THE LAST CLOCK PULSE, AND THE NUMBER OF COUNTED CLOCK PULSES

[FIG. 16]

1000

600

PCB Board

Signals

Signal
Interface

Start/Stop
Signals

602

603 — CLOCK

604 — POWER

1

FPGA

601 — USB/Ethernet/UART

USB/Ethernet/UART —701

CPU —702

Memory —703

700

Europäisches
Patentamt

European
Patent Office

Office européen
des brevets

# EUROPEAN SEARCH REPORT

**Application Number**

EP 25 20 7972

## DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| A | CN 118 502 220 A (UNIV CHONGQING TECHNOLOGY) 16 August 2024 (2024-08-16) * the whole document * ----- | 1-15 | INV. G04F10/00 |
| A | US 10 079 608 B2 (KUMAR PRIYANKA [NL]; STASZEWSKI ROBERT [NL] ET AL.) 18 September 2018 (2018-09-18) * the whole document * ----- | 1-15 | |

**TECHNICAL FIELDS SEARCHED (IPC)**

G04F

The present search report has been drawn up for all claims

| Place of search | Date of completion of the search | Examiner |
|---|---|---|
| The Hague | 17 February 2026 | Jacobs, Peter |

CATEGORY OF CITED DOCUMENTS

X : particularly relevant if taken alone
Y : particularly relevant if combined with another
document of the same category
A : technological background
O : non-written disclosure
P : intermediate document

T : theory or principle underlying the invention
E : earlier patent document, but published on, or
after the filing date
D : document cited in the application
L : document cited for other reasons

& : member of the same patent family, corresponding
document

EPO FORM 1503 03.82 (P04C01)

## ANNEX TO THE EUROPEAN SEARCH REPORT
## ON EUROPEAN PATENT APPLICATION NO.

EP 25 20 7972

This annex lists the patent family members relating to the patent documents cited in the above-mentioned European search report.
The members are as contained in the European Patent Office EDP file on
The European Patent Office is in no way liable for these particulars which are merely given for the purpose of information.

17-02-2026

| Patent document cited in search report | | Publication date | Patent family member(s) | | Publication date |
|---|---|---|---|---|---|
| CN 118502220 | A | 16-08-2024 | NONE | | |
| US 10079608 | B2 | 18-09-2018 | EP | 2753987 A2 | 16-07-2014 |
| | | | EP | 2753988 A2 | 16-07-2014 |
| | | | US | 2014226166 A1 | 14-08-2014 |
| | | | US | 2014232827 A1 | 21-08-2014 |
| | | | WO | 2013034770 A2 | 14-03-2013 |
| | | | WO | 2013034771 A2 | 14-03-2013 |

EPO FORM P0459

For more details about this annex : see Official Journal of the European Patent Office, No. 12/82